(19) **Europäisches Patentamt / European Patent Office / Office européen des brevets**

(11) **EP 1 934 973 B1**

(12) # EUROPEAN PATENT SPECIFICATION

(45) Date of publication and mention
of the grant of the patent:
**13.11.2019 Bulletin 2019/46**

(51) Int Cl.:
**G10L 19/008** (2013.01)     **H04S 3/00** (2006.01)

(21) Application number: **06777134.5**

(22) Date of filing: **31.08.2006**

(86) International application number:
**PCT/EP2006/008534**

(87) International publication number:
**WO 2007/042108 (19.04.2007 Gazette 2007/16)**

(54) **TEMPORAL AND SPATIAL SHAPING OF MULTI-CHANNEL AUDIO SIGNALS**

ZEITLICHES UND RÄUMLICHES FORMEN VON MEHRKANALIGEN AUDIOSIGNALEN

MISE EN FORME TEMPORELLE ET SPATIALE DE SIGNAUX AUDIO MULTICANAUX

(84) Designated Contracting States:
**AT BE BG CH CY CZ DE DK EE ES FI FR GB GR HU IE IS IT LI LT LU LV MC NL PL PT RO SE SI SK TR**

(30) Priority: **12.10.2005 US 726389 P**
**27.02.2006 US 363985**

(43) Date of publication of application:
**25.06.2008 Bulletin 2008/26**

(73) Proprietors:
• **Fraunhofer-Gesellschaft zur Förderung der angewandten Forschung e.V.**
**80686 München (DE)**
• **Koninklijke Philips N.V.**
**5656 AE Eindhoven (NL)**

(72) Inventors:
• **DISCH, Sascha**
**90763 Fürth (DE)**
• **HERRE, Jürgen**
**91054 Buckenhof (DE)**
• **NEUSINGER, Matthias**
**91189 Rohr (DE)**
• **BREEBAART, Jeroen**
**c/o Koninklijke Philips Electronics N.V.**
**NL-5621 BA Eindhoven (NL)**

• **HOTHO, Gerard**
**c/o Koninklijke Philips Electronics N.V.**
**NL-5621 BA Eindhoven (NL)**

(74) Representative: **Zinkler, Franz et al**
**Schoppe, Zimmermann, Stöckeler**
**Zinkler, Schenk & Partner mbB**
**Patentanwälte**
**Radlkoferstrasse 2**
**81373 München (DE)**

(56) References cited:
**EP-A- 1 385 150       EP-A- 1 565 036**
**WO-A-2006/045371**

• **HERRE J ET AL: "THE REFERENCE MODEL ARCHITECTURE FOR MPEG SPATIAL AUDIO CODING" AUDIO ENGINEERING SOCIETY CONVENTION PAPER, NEW YORK, NY, US, 28 May 2005 (2005-05-28), pages 1-13, XP009059973**
• **VILLEMOES L, HERRE J, BREEBART J, HOTHO G, DISCH S, PURNHAGEN H, KJÖRLING K: "MPEG Surround: the forthcoming ISO standard for spatial audio coding" AES 28TH CONFERENCE, 30 June 2006 (2006-06-30), - 2 July 2006 (2006-07-02) pages 1-18, XP002405379 Pitea, Sweden**

**Description**

Field of the Invention

The present invention relates to coding of multi-channel audio signals and in particular to a concept to improve the spatial perception of a reconstructed multi-channel signal.

Background of the invention and prior art

Recent development in audio coding has made available the ability to recreate a multi-channel representation of an audio signal based on a stereo (or mono) signal and corresponding control data. These methods differ substantially from older matrix based solutions such as Dolby Prologic, since additional control data is transmitted to control the re-creation, also referred to as up-mix, of the surround channels based on the transmitted mono or stereo channels.

Hence, the parametric multi-channel audio decoders reconstruct N channels based on M transmitted channels, where N > M, and based on the additional control data. The additional control data represents a significant lower data rate than transmitting all N channels, making the coding very efficient while at the same time ensuring compatibility with both M channel devices and N channel devices. The M channels can either be a single mono, a stereo, or a 5.1 channel representation. Hence, it is possible to have e.g. a 7.2 channel original signal down mixed to a 5.1 channel backwards compatible signal, and spatial audio parameters enabling a spatial audio decoder to re-produce a closely resembling version of the original 7.2 channels, at a small additional bit rate overhead.

These parametric surround-coding methods usually comprise a parameterisation of the surround signal based on ILD (Inter channel Level Difference) and ICC (Inter Channel Coherence). These parameters describe e.g. power ratios and correlation between channel pairs of the original multi-channel signal. In the decoding process, the re-created multi-channel signal is obtained by distributing the energy of the received downmix channels between all the channel pairs described by the transmitted ILD parameters. However, since a multi-channel signal can have equal power distribution between all channels, while the signals in the different channels are very different, thus giving the listening impression of a very wide (diffuse) sound, the correct wideness (diffuseness) is obtained by mixing the signals with decorrelated versions of the same. This mixing is described by the ICC parameter. The decorrelated version of the signal is obtained by passing the signal through an all-pass filter such as a reverberator.

This means that the decorrelated version of the signal is created on the decoder side and is not, like the downmix channels, transmitted from the encoder to the decoder. The output signals from the all-pass filters (decorrelators) have a time-response that is usually very flat. Hence, a dirac input signal gives a decaying noise-burst out. Therefore, when mixing the decorrelated and the original signal, it is for some signal types such as dense transients (applause signals) important to shape the time envelope of the decorrelated signal to better match that of the down-mix channel, which is often also called dry signal. Failing to do so will result in a perception of larger room size and unnatural sounding transient signals. Having transient signals and a reverberator as all-pass filter, even echo-type artefacts can be introduced when shaping of the decorrelated (wet) signals is omitted.

From a technical point of view, one of the key challenges in reconstructing multi-channel signals, as for example within a MPEG sound synthesis, consists in the proper reproduction of multi-channel signals with a very wide sound image. Technically speaking, this corresponds to the generation of several signals with low inter-channel correlation (or coherence), but still tightly control spectral and temporal envelopes. Examples for such signals are "applause" items, which exhibit both a high degree of decorrelation and sharp transient events (claps). As a consequence, these items are most critical for the MPEG surround technology which is for example elaborated in more detail in the "Report on MPEG Spatial Audio Coding RM0 Listening Tests", ISO/IEC JTC1/SC29/WG11 (MPEG), Document N7138, Busan, Korea, 2005". Generally previous work has focussed on a number of aspects relating to the optimal reproduction of wide/diffuse signals, such as applause by providing solutions that

1. adapt the temporal (and spectral) shape of the decorrelated signal to that of the transmitted downmix signal in order to prevent pre-echo - like artefacts (note: this does not require sending any side information from the spatial audio encoder to the spatial audio decoder).

2. adapt the temporal envelopes of the synthesized output channels to their original envelope shapes (present at the input of the corresponding encoder) using side information that describes the temporal envelopes of the original input signals and which is transmitted from the spatial audio encoder to the spatial audio decoder.

Currently, the MPEG Surround Reference Model already contains several tools supporting the coding of such signals, e.g.

- Time Domain Temporal Shaping (TP)
- Temporal Envelope Shaping (TES)

In an MPEG Surround synthesis system, decorrelated sound is generated and mixed with the "dry" signal in order to control the correlation of the synthesized output channels according to the transmitted ICC values. From here onwards, the decorrelated signal will be referred to as 'diffuse' signal, although the term 'diffuse' reflects properties of the reconstructed spatial sound field rather than properties of a signal itself. For transient signals, the diffuse sound generated in the decoder does not automatically match the fine temporal shape of the dry signals and does not fuse well perceptually with the dry signal. This results in poor transient reproduction, in analogy to the "pre-echo problem" which is known from perceptual audio coding. The TP tool implementing Time Domain Temporal Shaping is designed to address this problem by processing of the diffuse sound.

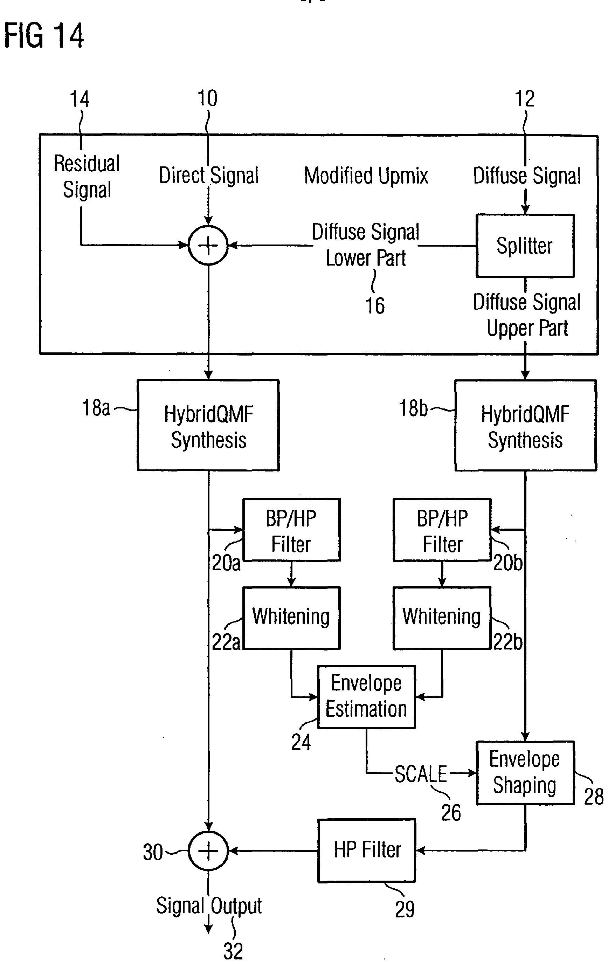

The TP tool is applied in the time domain, as illustrated in Fig. 14. It basically consists of a temporal envelope estimation of dry and diffuse signals with a higher temporal resolution than that provided by the filter bank of a MPEG Surround coder. The diffuse signal is re-scaled in its temporal envelope to match the envelope of the dry signal. This results in a significant increase in sound quality for critical transient signals with a broad spatial image / low correlation between channel signals, such as applause.

The envelope shaping (adjusting the temporal evolution of the energy contained within a channel) is done by matching the normalized short time energy of the wet signal to that one of the dry signal. This is achieved by means of a time varying gain function that is applied to the diffuse signal, such that the time envelope of the diffuse signal is shaped to match that one of the dry signal.

Note that this does not require any side information to be transmitted from the encoder to the decoder in order to process the temporal envelope of the signal (only control information for selectively enabling/disabling TP is transmitted by the surround encoder).

Fig. 14 illustrates the time domain temporal shaping, as applied within MPEG surround coding. A direct signal 10 and a diffuse signal 12 which is to be shaped are the signals to be processed, both supplied in a filterbank domain. Within MPEG surround, optionally a residual signal 14 may be available that is added to the direct signal 10 still within the filter bank domain. In the special case of an MPEG surround decoder, only high frequency parts of the diffuse signal 12 are shaped, therefore the low-frequency parts 16 of the signal are added to the direct signal 10 within the filter bank domain.

The direct signal 10 and the diffuse signal 12 are separately converted into the time domain by filter bank synthesis devices 18a, and 18b. The actual time domain temporal shaping is performed after the synthesis filterbank. Since only the high-frequency parts of the diffuse signal 12 are to be shaped, the time domain representations of the direct signal 10 and the diffuse signal 12 are input into high pass filters 20a and 20b that guarantee that only the high-frequency portions of the signals are used in the following filtering steps. A subsequent spectral whitening of the signals may be performed in spectral whiteners 22a and 22b to assure that the amplitude (energy) ratios of the full spectral range of the signals are accounted for in the following envelope estimation 24 which compares the ratio of the energies that are contained in the direct signal and in the diffuse signal within a given time portion. This time portion is usually defined by the frame length. The envelope estimation 24 has as an output a scale factor 26, that is applied to the diffuse signal 12 in the envelope shaping 28 in the time domain to guarantee that the signal envelope is basically the same for the diffuse signal 12 and the direct signal 10 within each frame.

Finally, the envelope shaped diffuse signal is again high-pass filtered by a high-pass filter 29 to guarantee that no artefacts of lower frequency bands are contained in the envelope shaped diffuse signal. The combination of the direct signal and the diffuse signal is performed by an adder 30. The output signal 32 then contains signal parts of the direct signal 10 and of the diffuse signal 12, wherein the diffuse signal was envelope shaped to assure that the signal envelope is basically the same for the diffuse signal 12 and the direct signal 10 before the combination.

The problem of precise control of the temporal shape of the diffuse sound can also be addressed by the so-called Temporal Envelope Shaping (TES) tool, which is designed to be a low complexity alternative to the Temporal Processing (TP) tool. While TP operates in the time domain by a time-domain scaling of the diffuse sound envelope, the TES approach achieves the same principal effect by controlling the diffuse sound envelope in a spectral domain representation. This is done similar to the Temporal Noise Shaping (TNS) approach, as it is known from MPEG-2/4 Advanced Audio Coding (AAC). Manipulation of the diffuse sound fine temporal envelope is achieved by convolution of its spectral coefficients across frequency with a suitable shaping filter derived from an LPC analysis of spectral coefficients of the dry signal. Due to the quite high time resolution of the MPEG Surround filter bank, TES processing requires only low-order filtering (1st order complex prediction) and is thus low in its computational complexity. On the other hand, due to limitations e.g. related to temporal aliasing, it cannot provide the full extent of temporal control that the TP tool offers.

Note that, similarly to the case of TP, TES does not require any side information to be transmitted from the encoder to the decoder in order to describe the temporal envelope of the signal.

Both tools, TP and TES, successfully address the problem of temporal shaping of the diffuse sound by adapting its temporal shape to that of the transmitted down mix signal. While this avoids the pre-echo type of unmasking, it cannot compensate for a second type of deficiency in the multi-channel output signal, which is due to the lack of spatial redistribution:

An applause signal consists of a dense mixture of transient events (claps) several of which typically fall into the same parameter frame. Clearly, not all claps in a frame originate from the same (or similar) spatial direction. For the MPEG Surround decoder, however, the temporal granularity of the decoder is largely determined by the frame size and the parameter slot temporal granularity. Thus, after synthesis, all claps that fall into a frame appear with the same spatial orientation (level distribution between output channels) in contrast to the original signal for which each clap may be localized (and, in fact, perceived) individually.

In order to also achieve good results in terms of spatial redistribution of highly critical signals such as applause signals, the time-envelopes of the upmixed signal need to be shaped with a very high time resolution.

EP 1 565 036 A discloses a scheme for stereo and multi-channel synthesis of inter-channel correlation (ICC) (normalized cross-correlation) cues for parametric stereo and multi-channel coding. The scheme synthesizes ICC cues such that they approximate those of the original. For that purpose, diffuse audio channels are generated and mixed with the transmitted combined (e.g., sum) signal(s). The diffuse audio channels are preferably generated using relatively long filters with exponentially decaying Gaussian impulse responses. Such impulse responses generate diffuse sound similar to late reverberation. An alternative implementation for reduced computational complexity is proposed, where inter-channel level difference (ICLD), inter-channel time difference (ICTD), and ICC synthesis are all carried out in the domain of a single short-time Fourier transform (STFT), including the filtering for diffuse sound generation.

EP 1 385 150 A discloses a method of parametrically encoding a transient audio signal, including the steps of: (a) determining a set V of the largest N frequency components of the transient audio signal, where N is a predetermined number; (b) determining an approximate envelope of the transient audio signal; and (c) determining a predetermined number P of samples W of the approximate envelope for generating a spline approximation of the approximate envelope; whereby a parametric representation of the transient audio signal is given by parameters including V, N, P and W, such that a decoder receiving the parametric representation can reproduce a received approximation of the transient audio signal.

Summary of the invention

It is the object of the present invention to provide a concept for coding multi-channel audio signals that allows efficient coding providing an improved preservation of the multi-channel signals spatial distribution.

In accordance with the first aspect of the present invention, this object is achieved by a decoder for generating a multi-channel output signal according to claim 1.

In accordance with a second aspect of the present invention, this object is achieved by an encoder for generating a wave form parameter representation of a channel of a multi-channel signal represented by frames, a frame comprising sampling values having a sampling period according to claim 18.

In accordance with a third aspect of the present invention, this object is achieved by a method for generating a multi-channel output signal according to claim 23.

In accordance with a fourth aspect of the present invention, this object is achieved by a method for generating a wave form parameter representation of a channel of a multi-channel signal represented by frames, a frame comprising sampling values having a sampling period according to claim 24. In accordance with a fifth aspect of the present invention, this object is achieved by a representation of a multi-channel audio signal according to claim 25.

In accordance with a sixth aspect of the present invention, this object is achieved by a computer readable storage medium according to claim 26.

In accordance with a seventh aspect of the present invention, this object is achieved by a receiver or audio player according to claim 27.

In accordance with an eighth aspect of the present invention, this object is achieved by a transmitter or audio recorder according to claim 28.

In accordance with a ninth aspect of the present invention, this object is achieved by a method of receiving or audio playing according to claim 29.

In accordance with a tenth aspect of the present invention, this object is achieved by a method of transmitting or audio recording according to claim 30.

In accordance with a eleventh aspect of the present invention, this object is achieved by a transmission system having a transmitter and a receiver according to claim 31.

In accordance with a twelfth aspect of the present invention, this object is achieved by a method of transmitting and receiving according to claim 32.

In accordance with a thirteenth aspect of the present invention, this object is achieved by a computer program having a program code for, when running a computer, performing any of the above methods.

The present invention is based on the finding that a selected channel of a multi-channel signal which is represented by frames composed from sampling values having a high time resolution can be encoded with higher quality when a wave form parameter representation representing a wave form of a low time resolution representation of the selected channel is derived, the wave form parameter representation including a sequence of wave form parameters having a time resolution lower than the high time resolution of the sampling values and higher than a time resolution defined by a frame repetition rate. The wave form parameter representation with the low resolution can be used to shape a reconstructed channel to retrieve a channel having a signal envelope close to that one of the selected original channel. The time scale on which the shaping is performed is finer than the time scale of a framewise processing, thus enhancing the quality of the reconstructed channel. On the other hand, the shaping time scale is coarser than the time scale of the sampling values, significantly reducing the amount of data needed by the wave form parameter representation.

A waveform parameter representation being suited for envelope shaping may in a preferred embodiment of the present invention contain a signal strength measure as parameters which is indicating the strength of the signal within a sampling period. Since the signal strength is highly related to the perceptual loudness of a signal, using signal strength parameters is therefore a suited choice for implementing envelope shaping. Two natural signal strength parameters are for example the amplitude or the squared amplitude, i.e. the energy of the signal.

The present invention aims for providing a mechanism to recover the signals spatial distribution on a high temporal granularity and thus recover the full sensation of "spatial distribution as it is relevant e.g. for applause signals. An important side condition is that the improved rendering performance is achieved without an unacceptably high increase in transmitted control information (surround side information).

The present invention described in the subsequent paragraphs primarily relates to multi-channel reconstruction of audio signals based on an available down-mix signal and additional control data. Spatial parameters are extracted on the encoder side representing the multi-channel characteristics with respect to a (given) down-mix of the original channels. The down mix signal and the spatial representation is used in a decoder to recreate a closely resembling representation of the original multi-channel signal by means of distributing a combination of the down-mix signal and a decorrelated version of the same to the channels being reconstructed.

The invention is applicable in systems where a backwards-compatible down-mix signal is desirable, such as stereo digital radio transmission (DAB, XM satellite radio, etc.), but also in systems that require very compact representation of the multi-channel signal. In the following paragraphs, the present invention is described in its application within the MPEG surround audio standard. It goes without saying that it is also applicable within other multi-channel audio coding systems, as for example the ones mentioned above.

The present invention is based on the following considerations:

- For optimal perceptual audio quality, an MPEG Surround synthesis stage must not only provide means for decorrelation, but also be able to re-synthesize the signal's spatial distribution on a fine temporal granularity.

- This requires the transmission of surround side information representing the spatial distribution (channel envelopes) of the multi-channel signal.

- In order to minimize the required bit rate for a transmission of the individual temporal channel envelopes, this information is coded in a *normalized and related fashion* relative to the envelope of the down mix signal. An additional entropy-coding step follows to further reduce the bit rate required for the envelope transmission.

- In accordance with this information, the MPEG Surround decoder shapes both the direct and the diffuse sound (or the combined direct/diffuse sound) such that it matches the temporal target envelope. This enables the independent control of the individual channel envelopes and recreates the perception of spatial distribution at a fine temporal granularity, which closely resembles the original (rather than frame-based, low resolution spatial processing by means of decorrelation techniques only).

The principle of guided envelope shaping can be applied in both the spectral and the time domain wherein the implementation in the spectral domain feature's lower computational complexity.

In one embodiment of the present invention a selected channel of a multi-channel signal is represented by a parametric representation describing the envelope of the channel, wherein the channel is represented by frames of sampling values having a high sampling rate, i.e. a high time resolution. The envelope is being defined as the temporal evolution of the energy contained in the channel, wherein the envelope is typically computed for a time interval corresponding to the frame length. In the present invention, the time slice for which a single parameter represents the envelope is decreased with respect to the time scale defined by a frame, i.e. this time slice is an intermediate time interval being longer than the sampling interval and shorter than the frame length. To achieve this, a low time resolution representation of the selected channel is computed that describes a frame with reduced temporal resolution compared to the resolution provided by the sampling parameters. The envelope of the selected channel is estimated with the time resolution of the low resolution representation which, on the one hand, increases the temporal resolution of the lower resolution representation and, on the other hand, decreases the amount of data and the computational complexity that is needed compared to a shaping in the time domain.

In a preferred embodiment of the present invention the low time resolution representation of the selected channel is provided by a filter bank that derives a down-sampled filter bank representation of the selected channel. In the filter bank representation each channel is split into a number of finite frequency bands, each frequency band being represented by a number of sampling values that describe the temporal evolution of the signal within the selected frequency band with a time resolution that is smaller than the time resolution of the sampling values.

The application of the present invention in the filter bank domain has a number of great advantages. The implementation fits well into existing coding schemes, i.e. the present invention can be implemented fully backwards compatible to existing audio coding schemes, such as MPEG surround audio coding. Furthermore, the required reduction of the temporal resolution is provided automatically by the down-sampling properties of the filter bank and a whitening of a spectrum can be implemented with much lower computational complexity in the filter bank domain than in the time domain. A further advantage is that the inventive concept may only be applied to frequency parts of the selected channel that need the shaping from a perceptual quality point of view.

In a further preferred embodiment of the present invention a waveform parameter representation of a selected channel is derived describing a ratio between the envelope of the selected channel and the envelope of a down-mix signal derived on the encoder side. Deriving the waveform parameter representation based on a differential or relative estimate of the envelopes has the major advantage of further reducing the bit rate demanded by the waveform parameter representation. In a further preferred embodiment the so-derived waveform parameter representation is quantized to further reduce the bit rate needed by the waveform parameter representation. It is furthermore most advantageous to apply an entropy coding to the quantized parameters for saving more bit rate without further loss of information.

In a further preferred embodiment of the present invention the wave form parameters are based on energy measures describing the energy contained in the selected channel for a given time portion. The energy is preferably calculated as the squared sum of the sampling parameters describing the selected channel.

In a further embodiment of the present invention the inventive concept of deriving a waveform parameter representation based on a low resolution representation of a selected audio channel of a multi-channel audio signal is implemented in the time domain. The required deriving of the low resolution representation can be achieved by computing the (squared) average or energy sum of a number of consecutive sampling values. The variation of the number of consecutive sampling values which are averaged allows convenient adjustment of the time resolution of the envelope shaping process. In a modification of the previously described embodiment only every n-th sampling value is used for the deriving of the waveform parameter representation, further decreasing the computational complexity.

In a further embodiment of the present invention the deriving of the shaping parameters is performed with comparatively low computational complexity in the frequency domain wherein the actual shaping, i.e. the application of the shaping parameters is performed in the time domain.

In a further embodiment of the present invention the envelope shaping is applied only on those portions of the selected channel that do require an envelope shaping with high temporal resolution.

The present invention described in the previous paragraphs yields the following advantages:

- Improvement of spatial sound quality of dense transient sounds, such as applause signals, which currently can be considered worst-case signals.

- Only moderate increase in spatial audio side information rate (approximately 5 kbit/s for continuous transmission of envelopes) due to very compact coding of the envelope information.

- The overall bit rate might be furthermore reduced by letting the encoder transmit envelopes only when it is perceptually necessary. The proposed syntax of the envelope bit stream element takes care of that.

The inventive concept can be described as guided envelope shaping and shall shortly be summarized within the following paragraphs:

The guided envelope shaping restores the broadband envelope of the synthesized output signal by envelope flattening and reshaping of each output channel using parametric broadband envelope side information contained in the bit stream.

For the reshaping process the envelopes of the downmix and the output channels are extracted. To obtain these envelopes, the energies for each parameter band and each slot are calculated. Subsequently, a spectral whitening operation is performed, in which the energy values of each parameter band are weighted, so that the total energy of all parameter bands is equal. Finally, the broadband envelope is obtained by summing and normalizing the weighted energies of all parameter bands and a long term averaged energy is obtained by low pass filtering with a long time constant.

The envelope reshaping process performs flattening and reshaping of the output channels towards the target envelope, by calculating and applying a gain curve on the direct and the diffuse sound portion of each output channel. Therefore, the envelopes of the transmitted down mix and the respective output channel are extracted as described above. The gain curve is then obtained by scaling the ratio of the extracted down mix envelope and the extracted output envelope with the envelope ratio values transmitted in the bit stream.

The proposed envelope shaping tool uses quantized side information transmitted in the bit stream. The total bit rate demand for the envelope side information is listed in Table 1 (assuming 44.1 kHz sampling rate, 5 step quantized envelope side information).

**Table 1 - Estimated bitrate for envelope side information**

| coding method | estimated bitrate |
|---|---|
| Grouped PCM Coding | ~8.0 kBit/s |
| Entropy Coding | ~5.0 kBit/s |

As stated before the guided temporal envelope shaping addresses issues that are orthogonal to those addressed by TES or TP: While the proposed guided temporal envelope shaping aims at improving spatial distribution of transient events, the TES and the TP tool is functional to shape the diffuse sound envelope to match the dry envelope. Thus, for a high quality application scenario, a combination of the newly proposed tool with TES or TP is recommended. For optimal performance, guided temporal envelope shaping is performed before application of TES or TP in the decoder tool chain. Furthermore the TES and the TP tools are slightly adapted in their configuration to seamlessly integrate with the proposed tool: Basically, the signal used to derive the target envelope in TES or TP processing is changed from using the down mix signal towards using the reshaped individual channel up mix signals.

As already mentioned above, a big advantage of the inventive concept is its possibility to be placed within the MPEG surround coding scheme. The inventive concept on the one hand extends the functionality of the TP/TES tool since it implements the temporal shaping mechanism needed for proper handling of transient events or signals. On the other hand, the tool requires the transmission of side information to guide the shaping process. While the required average side information bit rate (ca. 5 KBit/s for continuous envelope transmission) is comparatively low, the gain in conceptual quality is significant. Consequently, the new concept is proposed as an addition to the existing TP/TES tools. In the sense of keeping computational complexity rather low while still maintaining high audio quality, the combination of the newly proposed concept with TES is a preferred operation mode. As it comes to computational complexity, it may be noted that some of the calculations required for the envelope extraction and reshaping on a per frame basis, while others are executed by slot (i.e. a time interval within the filter bank domain). The complexity is dependent on the frame length as well as on the sampling frequency. Assuming a frame length of 32 slots and a sampling rate of 44.1 KHz, the described algorithm requires approximately 105.000 operations per second (OPS) for the envelope extraction for one channel and 330.000 OPS for the reshaping of one channel. As one envelope extraction is required per down-mix channel and one reshaping operation is required for each output channel, this results in a total complexity of 1.76 MOPS for a 5-1-5 configuration, i.e. a configuration where 5 channels of a multi-channel audio signal are represented by a monophonic down-mix signal and 1.86 MOPS for the 5-2-5 configuration utilizing a stereo down-mix signal.

Brief description of the drawings

Preferred embodiments of the present invention are subsequently described by referring to the enclosed drawings, wherein:

Fig. 1　　　　　shows an inventive decoder;

Fig. 2　　　　　shows an inventive encoder;

Figs. 3a and 3b　show a table assigning filter band indices of a hybrid filter bank to corresponding subband indices;

Fig. 4　　　　　shows parameters of different decoding configurations;

Fig. 5　　　　　shows a coding scheme illustrating the backwards compatibility of the inventive concept;

Fig.6　　　　　shows parameter configurations selecting different configurations;

Fig. 7            shows a backwards-compatible coding scheme;

Fig. 7b           illustrates different quantization schemes;

Fig. 8            further illustrates the backwards-compatible coding scheme;

Fig. 9            shows a Huffman codebook used for an efficient implementation;

Fig.10            shows an example for a channel configuration of a multi-channel output signal;

Fig. 11           shows an inventive transmitter or audio recorder;

Fig. 12           shows an inventive receiver or audio player;

Fig. 13           shows an inventive transmission system; and

Fig. 14           illustrates prior art time domain temporal shaping.

Detailed description of preferred embodiments

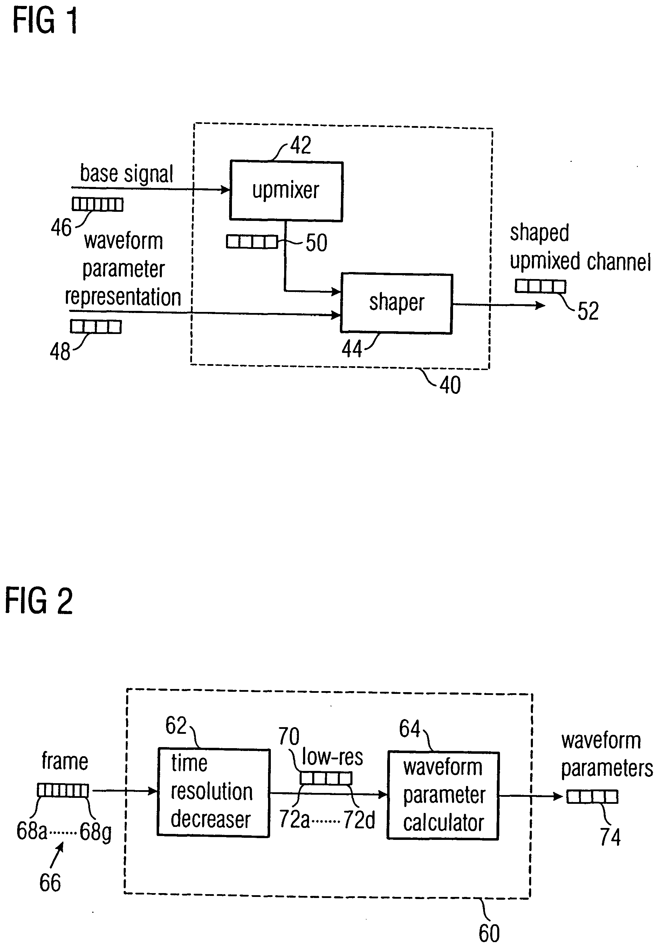

Fig. 1 shows an inventive decoder 40 having an upmixer 42 and a shaper 44.

The decoder 40 receives as an input a base signal 46 derived from an original multi-channel signal, the base signal having one or more channels, wherein the number of channels of the base signal is lower than the number of channels of the original multi-channel signal. The decoder 40 receives as second input a wave form parameter representation 48 representing a wave form of a low resolution representation of a selected original channel, wherein the wave form parameter representation 48 is including a sequence of wave form parameters having a time resolution that is lower than the time resolution of a sampling values that are organized in frames, the frames describing the base signal 46. The upmixer 42 is generating an upmix channel 50 from the base signal 46, wherein the upmix 50 is a low-resolution estimated representation of a selected original channel of the original multi-channel signal that is having a lower time resolution than the time resolution of the sampling values. The shaper 44 is receiving the up-mix channel 50 and the wave form parameter representation 48 as input and derives a shaped up-mixed channel 52 which is shaped such that the envelope of the shaped up-mixed channel 52 is adjusted to fit the envelope of the corresponding original channel within a tolerance range, wherein the time resolution is given by the time resolution of the wave form parameter representation.

Thus, the envelope of the shaped up-mixed channel can be shaped with a time resolution that is higher than the time resolution defined by the frames building the base signal 46. Therefore, the spatial redistribution of a reconstructed signal is guaranteed with a finer temporal granularity than by using the frames and the perceptual quality can be enhanced at the cost of a small increase of bit rate due to the wave form parameter representation 48.

Fig. 2 shows an inventive encoder 60 having a time resolution decreaser 62 and a waveform parameter calculator 64. The encoder 60 is receiving as an input a channel of a multi-channel signal that is represented by frames 66, the frames comprising sampling values 68a to 68g, each sampling value representing a first sampling period. The time resolution decreaser 62 is deriving a low-resolution representation 70 of the channel in which a frame is having low-resolution values 72a to 72d that are associated to a low-resolution period being larger than the sampling period.

The wave form parameter calculator 64 receives the low resolution representation 70 as input and calculates wave form parameters 74, wherein the wave form parameters 74 are having a time resolution lower than the time resolution of the sampling values and higher than a time resolution defined by the frames.

The waveform parameters 74 are preferably depending on the amplitude of the channel within a time portion defined by the low-resolution period. In a preferred embodiment, the waveform parameters 74 are describing the energy that is contained within the channel in a low-resolution period. In a preferred embodiment, the waveform parameters are derived such that an energy measure contained in the waveform parameters 74 is derived relative to a reference energy measure that is defined by a down-mix signal derived by the inventive multi-channel audio encoder.

The application of the inventive concept in the context of an MPEG surround audio encoder is described in more detail within the following paragraphs to outline the inventive ideas.

The application of the inventive concept within the subband domain of a prior art MPEG encoder further underlines the advantageous backwards compatibility of the inventive concept to prior art coding schemes.

The present invention (guided envelope shaping) restores the broadband envelope of the synthesized output signal. It comprises a modified upmix procedure followed by envelope flattening and reshaping of the direct (dry) and the diffused (wet) signal portion of each output channel. For steering the reshaping parametric broadband envelope side information contained in the bit stream is used. The side information consists of ratios (envRatio) relating the transmitted downmix signals envelope to the original input channel signals envelope.

As the envelope shaping process employs an envelope extraction operation on different signals, the envelope extraction process shall first be described in more detail. It is to be noted that within the MPEG coding scheme the channels are manipulated in a representation derived by a hybrid filter bank, that is two consecutive filters are applied to an input channel. A first filter bank derives a representation of an input channel in which a plurality of frequency intervals are described independently by parameters having a time resolution that is lower than the time resolution of the sampling values of the input channel. These parameter bands are in the following denoted by the letter κ. Some of the parameter bands are subsequently filtered by an additional filter bank that is further subdividing some the frequency bands of the first filterbank in one or more finite frequency bands with representations that are denoted k in the following paragraphs. In other words, each parameter band κ may have associated more than one hybrid index k.

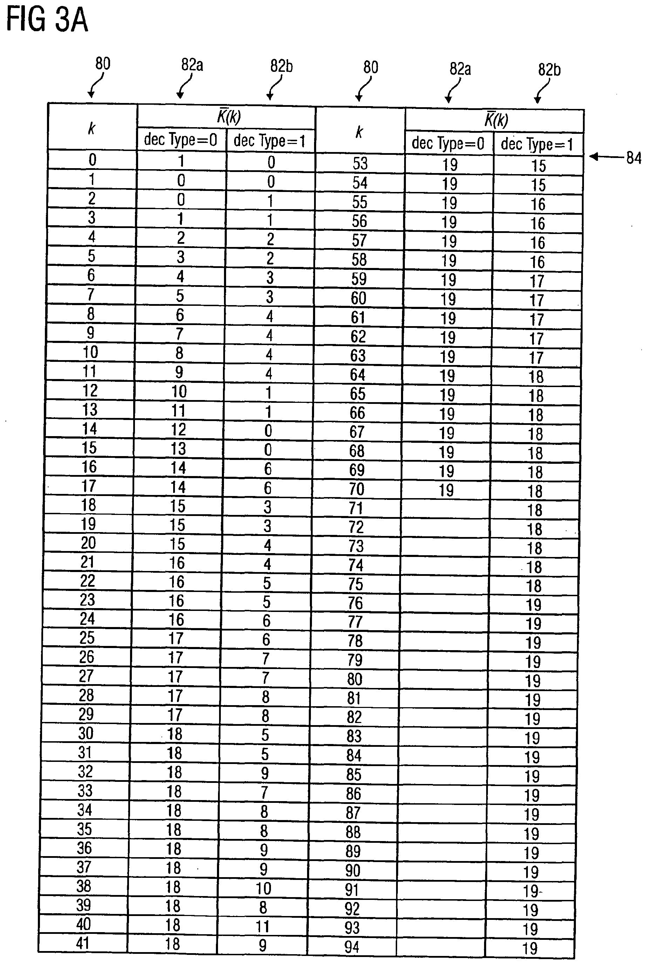

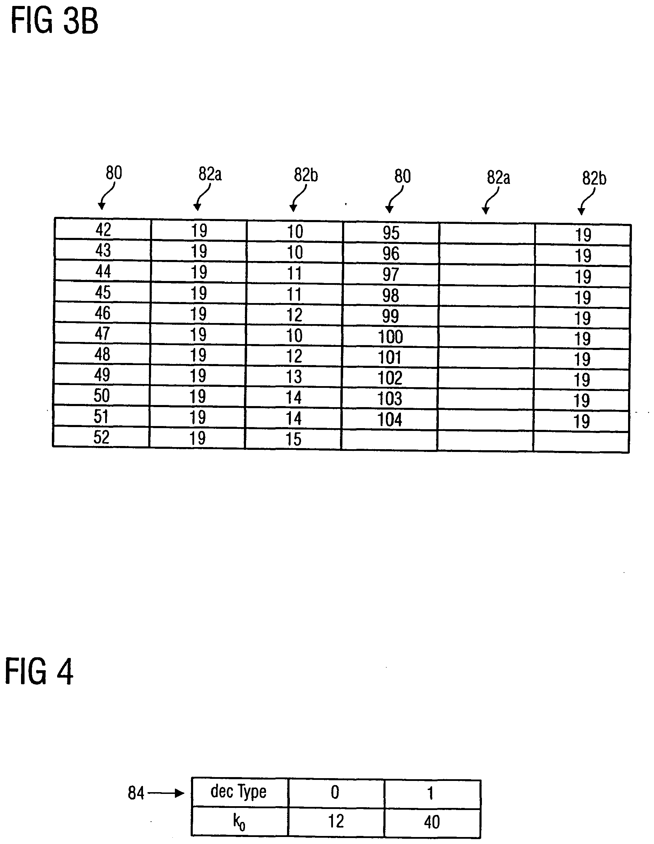

Figs. 3a and 3b show a table associating a number of parameter bands to the corresponding hybrid parameters. The hybrid parameter k is given in the first column 80 of the table wherein the associated parameter band κ is given in one of the columns 82a or 82b. The application of column 82a or 82b is depending on a parameter 84 (decType) that indicates two different possible configurations of an MPEG decoder filterbank.

It is further to be noted that the parameters associated to a channel are processed in a frame-wise fashion, wherein a single frame is having n time intervals and wherein for each time interval n a single parameter y exists for every hybrid index k. The time intervals n are also called slots and the associated parameters are indicated $y^{n,k}$. For the estimation of the normalized envelope, the energies of the parameter bands are calculated with $y^{n,k}$ being the input signal for each slot in a frame:

$$E_{slot}^{n,\kappa} = \sum_{\tilde{k}} y^{n,k} y^{n,k*} \quad , \tilde{k} = \left\{ k \mid \overline{\kappa}(k) = \kappa \right\}$$

The summation includes all k being attributed to all parameter bands κ according to the table shown in Figs. 3a and 3b.

Subsequently, the total parameter band energy in the frame for each parameter band is calculated as

$$E_{frame}^{\kappa}(t+1) = (1-\alpha) \sum_{n=0}^{numSlots-1} E_{slot}^{n,\kappa} + \alpha E_{frame}^{\kappa}(t) \quad ,$$

$$\alpha = \exp\left( \frac{-1*64*numSlots}{0.4*sFreq} \right) .$$

With $\alpha$ being a weighting factor corresponding to a first order IIR low pass with 400 ms time constant. t is denoting the frame index, sFreq the sampling rate of the input signal, and 64 represents the down-sample factor of the filter bank. The mean energy in a frame is calculated to be

$$E_{total} = \frac{1}{\kappa_{stop} - \kappa_{start} + 1} \sum_{\kappa=\kappa_{start}}^{\kappa_{stop}} E_{frame}^{\kappa} \quad ,$$

with $\kappa_{start}$ =10 and $\kappa_{stop}$ =18 .

The ratio of these energies is determined to obtain weights for spectral whitening:

$$w^{\kappa} = \frac{E_{total}}{E_{frame}^{\kappa} + \varepsilon} .$$

The broadband envelope is obtained by summation of the weighted contributions of the parameter bands, normalizing and calculation of the square root

$$Env = \sqrt{\frac{\sum_{\kappa=\kappa_{start}}^{\kappa_{stop}} w^{\kappa} \cdot E_{slot}^{n,\kappa}(t+1)}{\sum_{n=0}^{numSlots-1} \sum_{\kappa=\kappa_{start}}^{\kappa_{stop}} w^{\kappa} \cdot E_{slot}^{n,\kappa}(t+1)}} .$$

After the envelope extraction, the envelope shaping process is performed, which is consisting of a flattening of the direct and the diffuse sound envelope for each output channel followed by a reshaping towards a target envelope. This is resulting in a gain curve being applied to the direct and the diffuse signal portion of each output channel.

In the case of a MPEG surround compatible coding scheme, a 5-1-5 and a 5-2-5 configuration have to be distinguished.

For 5-1-5 configuration the target envelope is obtained by estimating the envelope of the transmitted down mix $Env_{Dmx}$ and subsequently scaling it with encoder transmitted and requantized envelope ratios $envRatio^{L,Ls,C,R,Rs}$. The gain curve for all slots in a frame is calculated for each output channel by estimating the envelope $Env_{direct,diffuse}^{L,Ls,C,R,Rs}$ of the direct and the diffuse signal respectively and relate it to the target envelope

$$g_{direct,diffuse}^{L,Ls,C,R,Rs} = \frac{envRatio^{L,Ls,C,R,Rs} \cdot Env_{Dmx}}{Env_{direct,diffuse}^{L,Ls,C,R,Rs}}$$

For 5-2-5 configurations the target envelope for L and Ls is derived from the left channel compatible transmitted down mix signal's envelope $Env_{DmxL}$, for R and Rs the right channel compatible transmitted down mix is used to obtain $Env_{DmxR}$. The center channel is derived from the sum of left and right compatible transmitted down mix signal's envelopes.

The gain curve is calculated for each output channel by estimating the envelope $Env_{direct,diffuse}^{L,Ls,C,R,Rs}$ of the direct and the diffuse signal respectively and relate it to the target envelope

$$g_{direct,diffuse}^{L,Ls} = \frac{envRatio^{L,Ls} \cdot Env_{DmxL}}{Env_{direct,diffuse}^{L,Ls}}$$

$$g_{direct,diffuse}^{R,Rs} = \frac{envRatio^{R,Rs} \cdot Env_{DmxR}}{Env_{direct,diffuse}^{R,Rs}}$$

$$g_{direct,diffuse}^{C} = \frac{envRatio^{C} \cdot 0.5\left(Env_{DmxL} + Env_{DmxR}\right)}{Env_{direct,diffuse}^{C}} .$$

For all channels, the envelope adjustment gain curve is applied as

$$y_{direct}^{n,k} = g_{direct}^{n} \cdot y_{direct}^{n,k}$$

$$y_{diffuse}^{n,k} = g_{diffuse}^{n} \cdot y_{diffuse}^{n,k} .$$

With $k$ starting at the crossover hybrid subband $k_0$ and for $n = 0,...,numSlots-1$.

After the envelope shaping of the wet and the dry signals separately, the shaped direct and diffuse sound is mixed within the subband domain according to the following formula:

$$y^{n,k} = y_{direct}^{n,k} + y_{diffuse}^{n,k}$$

It has been shown in the previous paragraphs that it is advantageously possible to implement the inventive concept within a prior art coding scheme which is based on MPEG surround coding. The present invention also makes use of an already existing subband domain representation of the signals to be manipulated, introducing little additional computational effort. To increase the efficiency of an implementation of the inventive concept into MPEG multi-channel audio coding, some additional changes in the upmixing and the temporal envelope shaping are preferred.

If the guided envelope shaping is enabled, direct and diffuse signals are synthesized separately using a modified post mixing in the hybrid subband domain according to

$$y_{direct}^{n,k} = \begin{cases} \mathbf{M}_{2\_dry}^{n,k}\mathbf{w}^{n,k} + \mathbf{M}_{2\_wet}^{n,k}\mathbf{w}^{n,k} & ,0 \le k < k_0 \\ \mathbf{M}_{2\_dry}^{n,k}\mathbf{w}^{n,k} & ,k_0 \le k < K \end{cases}$$

$$y_{diffuse}^{n,k} = \begin{cases} 0 & ,0 \le k < k_0 \\ \mathbf{M}_{2\_wet}^{n,k}\mathbf{w}^{n,k} & ,k_0 \le k < K \end{cases}.$$

with $k_0$ denoting the crossover hybrid subband.

As can be seen from the above equations, the direct outputs hold the direct signal, the diffuse signal for the lower bands and the residual signal (if present). The diffuse outputs provide the diffuse signal for the upper bands.

Here, $k_0$ is denoting the crossover hybrid subband according to Fig. 4. Fig. 4 shows a table that is giving the crossover hybrid subband $k_0$ in dependence of the two possible decoder configurations indicated by parameter 84 (decType).

If TES is used in combination with guided envelope shaping, the TES processing is slightly adapted for optimal performance:

instead of the downmix signals, the reshaped direct upmix signals are used for the shaping filter estimation:

$$x_c = y_{direct,c}$$

Independent of the 5-1-5 or 5-2-5 mode all TES calculations are performed accordingly on a per-channel basis. Furthermore, the mixing step of direct and diffuse signals is omitted in the guided envelope shaping then as it is performed by TES.

If TP is used in combination with the guided envelope shaping the TP processing is slightly adapted for optimal performance:

Instead of a common downmix (derived from the original multi-channel signal) the reshaped direct upmix signal of each channel is used for extracting the target envelope for each channel.

$$\hat{y}_{direct} = \tilde{y}_{direct}$$

Independent of the 5-1-5 or 5-2-5 mode all TP calculations are performed accordingly on a per-channel basis. Furthermore, the mixing step of direct and diffuse signal is omitted in the guided envelope shaping and is performed by TP.

To further emphasize and give proof for a backwards compatibility of the inventive concept with MPEG audio coding, the following figures show bit stream definitions and functions defined to be fully backwards compatible and additionally supporting quantized envelope reshaping data.

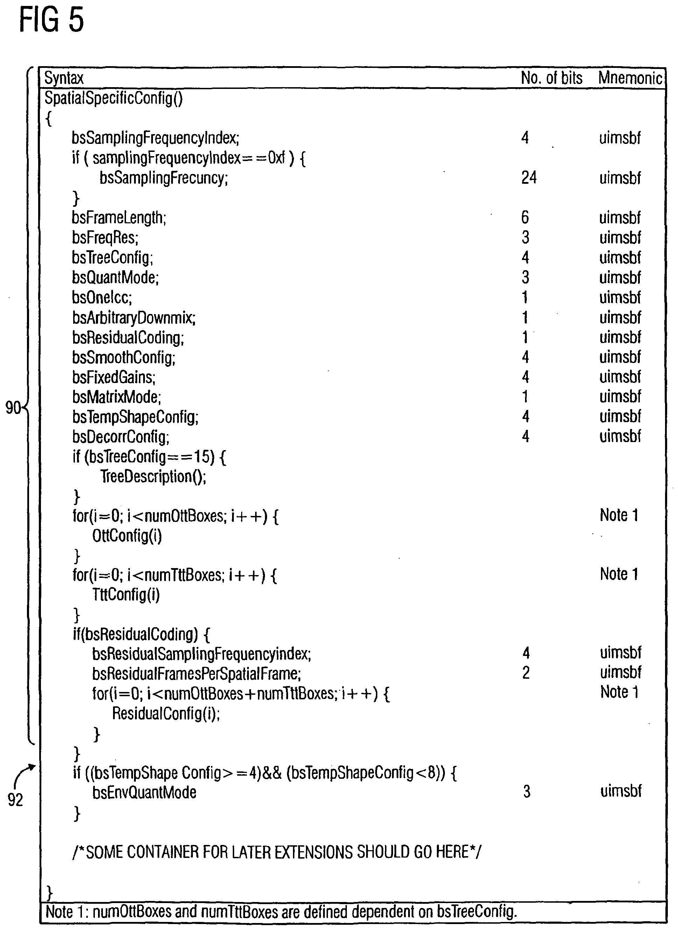

Fig. 5 shows a general syntax describing the spatial specific configuration of a bit stream.

In a first part 90 of the configuration, the variables are related to prior art MPEG encoding defining for example whether residual coding is applied or giving indication about the decorrelation schemes to apply. This configuration can easily be extended by a second part 92 describing the modified configuration when the inventive concept of guided envelope shaping is applied.

In particular, the second part utilizes a variable bsTempShapeConfig, indicating the configuration of the envelope shaping applicable by a decoder.

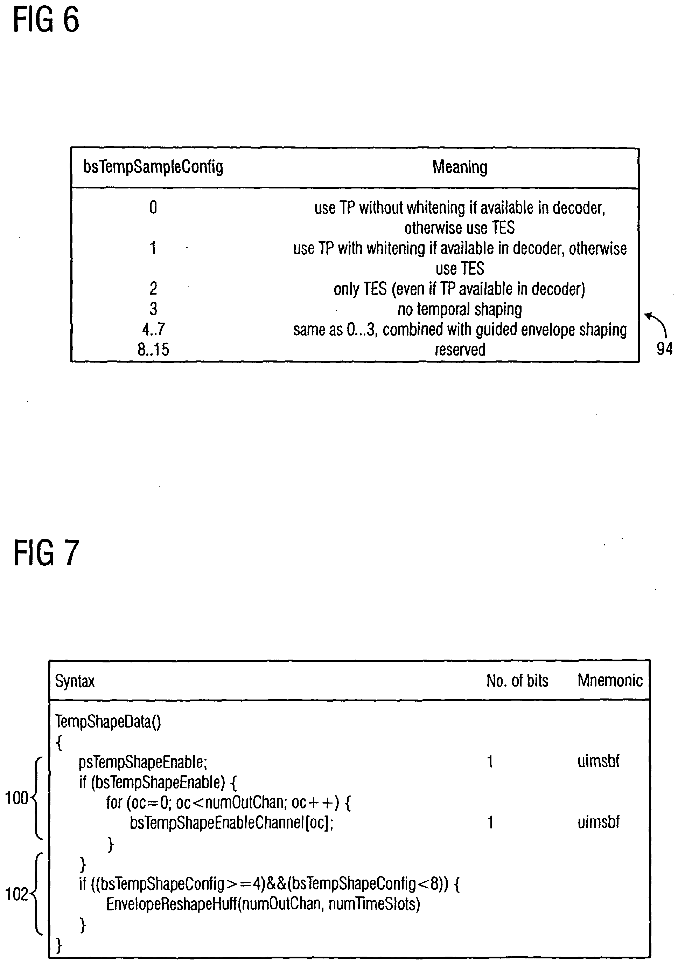

Fig. 6 shows a backwards compatible way of interpreting the four bits consumed by said variable. As can be seen from Fig. 6, variable values of 4 to 7 (indicated in line 94) indicate the use of the inventive concept and furthermore a combination of the inventive concept with the prior art shaping mechanisms TP and TES.

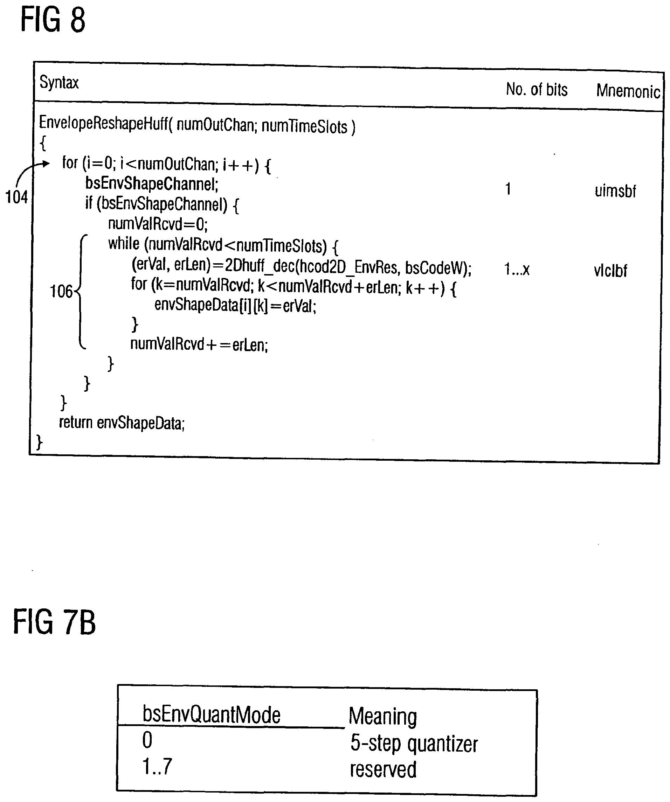

Fig. 7 outlines the proposed syntax for an entropy coding scheme as it is implemented in a preferred embodiment of the present invention. Additionally the envelope side information is quantized with a five step quantization rule.

In a first part of the pseudo-code presented in Fig. 7 temporal envelope shaping is enabled for all desired output channels, wherein in a second part 102 of the code presented envelope reshaping is requested. This is indicated by the variable bsTempShapeConfig shown in Fig. 6.

In a preferred embodiment of the present invention, five step quantization is used and the quantized values are jointly encoded together with the information, whether one to eight identical consecutive values occurred within the bit stream of the envelope shaping parameters.

It should be noted that, in principle, a finer quantization as the proposed five step quantization is possible, which can then be indicated by a variable bsEnvquantMode as shown in Fig. 7b. Although principally possible, the present implementation introduces only one valid quantization.

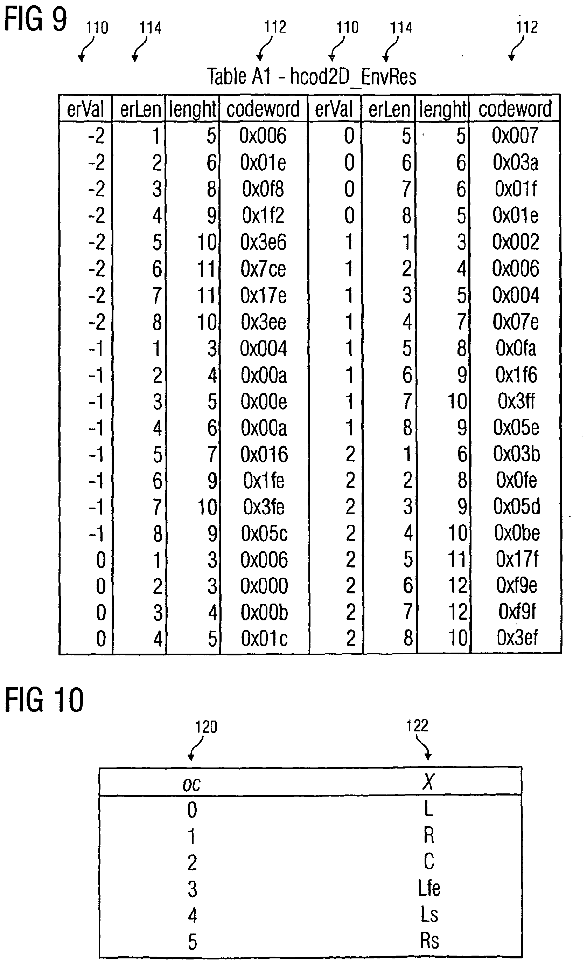

Fig. 8 shows code that is adapted to derive the quantized parameters from the Huffman encoded representation. As already mentioned, the combined information regarding the quantized value and the number of repetitions of the value in question are represented by a single Huffman code word. The Huffman decoding therefore comprises a first component 104 initiating a loop over the desired output channels and a second component 106 that is receiving the encoded values for each individual channel by transmitting Huffman code words and receiving associated parameter values and repetition data as indicated in Fig. 9.

Fig. 9 is showing the associated Huffman code book that has 40 entries, since for the 5 different parameter values 110 a maximum repetition rate of 8 is foreseen. Each Huffman code word 112 therefore describes a combination of the parameter 110 and the number of consecutive occurrence 114.

Given the Huffman decoded parameter values, the envelope ratios used for the guided envelope shaping are obtained from the transmitted reshaping data according to the following equation:

$$envRatio^{X,n} = 2^{\frac{envShapeData[oc][n]}{2}},$$

with $n = 0,...,numSlots-1$ and X and oc denoting the output channel according to Fig. 10.

Fig. 10 shows a table that is associating the loop variable oc 120, as used by the previous tables and expressions with the output channels 122 of a reconstructed multi-channel signal.

As it has been demonstrated by Figures 3a to 9, an application of the inventive concept to prior art coding schemes is easily possible, resulting in an increase in perceptual quality while maintaining fully backwards compatibility.

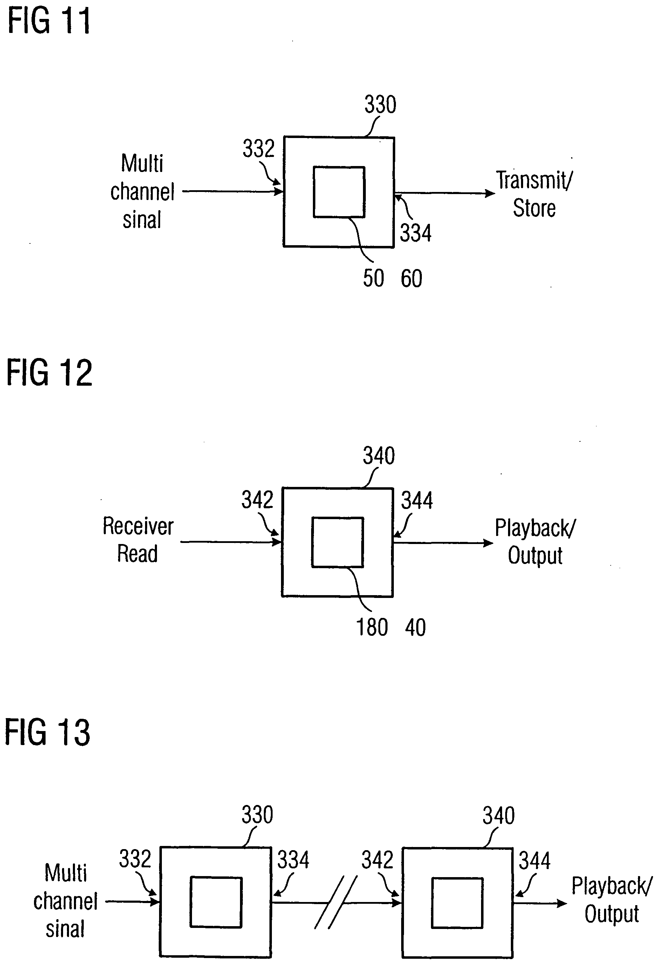

Fig.11 is showing an inventive audio transmitter or recorder 330 that is having an encoder 60, an input interface 332 and an output interface 334.

An audio signal can be supplied at the input interface 332 of the transmitter/recorder 330. The audio signal is encoded by an inventive encoder 60 within the transmitter/recorder and the encoded representation is output at the output interface 334 of the transmitter/recorder 330. The encoded representation may then be transmitted or stored on a storage medium.

Fig. 12 shows an inventive receiver or audio player 340, having an inventive decoder 40, a bit stream input 342, and an audio output 344.

A bit stream can be input at the input 342 of the inventive receiver/audio player 340. The bit stream then is decoded by the decoder 40 and the decoded signal is output or played at the output 344 of the inventive receiver/audio player 340.

Fig. 13 shows a transmission system comprising an inventive transmitter 330, and an inventive receiver 340.

The audio signal input at the input interface 332 of the transmitter 330 is encoded and transferred from the output 334 of the transmitter 330 to the input 342 of the receiver 340. The receiver decodes the audio signal and plays back or outputs the audio signal on its output 344.

Summarizing, the present invention provides improved solutions by describing e.g.

- a way of calculating a suitable and stable broadband envelope which minimizes perceived distortion
- an optimized method to encode the envelope side information in a way that it is represented relative to (normalized to) the envelope of the downmix signal and in this way minimizes bitrate overhead
- a quantization scheme for the envelope information to be transmitted
- a suitable bitstream syntax for transmission of this side information
- an efficient method of manipulating broadband envelopes in the QMF subband domain
- a concept how the processing types (1) and (2), as described above, can be unified within a single architecture which is able to recover the fine spatial distribution of the multi-channel signals over time, if a spatial side information is available describing the original temporal channel envelopes. If no such information is sent in the spatial bitstream (e.g. due to constraints in available side information bitrate), the processing falls back to a type (1) processing which still can carry out correct temporal shaping of the decorrelated sound (although not on a channel individual basis).

Although the inventive concept described above has been extensively described in its application to existing MPEG coding schemes, it is obvious that the inventive concept can be applied to any other type of coding where spatial audio characteristics have to be preserved.

The inventive concept of introducing or using a intermediate signal for shaping the envelope i.e. the energy of a signal with an increased time resolution can be applied not only in the frequency domain, as illustrated by the figures but also in the time domain, where for example a decrease in time resolution and therefore a decrease in required bit rate can be achieved by averaging over consecutive time slices or by only taking into account every n-th sample value of a sample representation of an audio signal.

Although the inventive concept as illustrated in the previous paragraphs incorporates a spectral whitening of the processed signals the idea of having an intermediate resolution signal can also be incorporated without spectral whitening.

Depending on certain implementation requirements of the inventive methods, the inventive methods can be implemented in hardware or in software. The implementation can be performed using a digital storage medium, in particular a disk, DVD or a CD having electronically readable control signals stored thereon, which cooperate with a programmable computer system such that the inventive methods are performed. Generally, the present invention is, therefore, a computer program product with a program code stored on a machine-readable carrier, the program code being operative for performing the inventive methods when the computer program product runs on a computer. In other words, the inventive methods are, therefore, a computer program having a program code for performing at least one of the inventive methods when the computer program runs on a computer.

While the foregoing has been particularly shown and described with reference to particular embodiments thereof, it will be understood by those skilled in the art that various other changes in the form and details may be made without departing from the scope thereof. It is to be understood that various changes may be made in adapting to different embodiments without departing from the broader concepts disclosed herein and comprehended by the claims that follow.

**Claims**

1.   Decoder for generating a multi-channel output signal based on a base signal (46) derived from an original multi-channel signal having one or more channels, a number of channels of the base signal (46) being smaller than a number of channels of the original multi-channel signal, the base signal (46) having a frame (66), the frame (66) comprising sampling values (68a - 68g) having a high time resolution, wherein the generating the multi-channel output signal is additionally based on a wave form parameter representation (48) representing a wave form of a low time resolution representation of a selected original channel of the original multi-channel signal, wherein the wave form parameter representation (48) includes a sequence of wave form parameters (74), the sequence of wave form parameters (74) having a low time resolution lower than the high time resolution of the sampling values (68a - 68g) and higher than a time resolution defined by a frame repetition rate, comprising:
an upmixer (42) for generating a plurality of upmixed channels having a time resolution higher than the low time resolution and for deriving a low time resolution representation of the base signal (46) used to generate the upmixed channels; and a shaper (44) for deriving a reference wave form parameter representation (48) of the low time resolution representation of the base signal (46) and for shaping an envelope of a selected upmixed channel (50) using the reference wave form parameter representation (48) and the wave form parameters (74) of the selected original channel corresponding to the selected upmixed channel (50).

2.   Decoder in accordance with claim 1, in which the upmixer (42) is operative to derive the low time resolution representation of the base signal (46) using a filter bank, wherein the low time resolution representation of the base signal (46) is derived in a filter bank domain.

3.   Decoder in accordance with claim 2, in which the filter bank is a complex modulated filter bank.

4.   Decoder in accordance with claim 1, in which the upmixer (42) is having one or more decorrelators for deriving one or more decorrelated signals from the base signal (46).

5.   Decoder in accordance with claim 4, in which the upmixer (42) is operative such that the generation of the upmixed channels includes a linear combination of the channels of the base signal (46) and of the one or more decorrelated signals.

**6.** Decoder in accordance with claim 5, in which the shaper (44) is operative to shape the selected upmixed channel (50) such that a first part of the selected upmixed channel (50) derived from the base signal (46) is shaped independently from a second part of the selected upmixed channel (50) derived from the one or more decorrelated signals.

**7.** Decoder in accordance with claim 1, in which the shaper (44) is operative to use the wave form parameters (74) describing a signal strength measure of the intermediate time resolution representation of the selected original channel.

**8.** Decoder in accordance with claim 7, in which the shaper (44) is operative to use the wave form parameters (74) describing the signal strength measure having an amplitude or an energy measure.

**9.** Decoder in accordance with claim 1, in which the shaper (44) is operative to shape the selected upmixed channel (50) such that the shaping comprises a combination of the parameters from the wave form parameter representation (48) and from the reference wave form parameter representation (48).

**10.** Decoder in accordance with claim 1, in which the shaper (44) is operative to derive a spectrally flat representation of the low time resolution representation of the base signal (46), the spectrally flat representation having a flat frequency spectrum, and to derive the reference wave form parameter representation (48) from the spectrally flat representation.

**11.** Decoder in accordance with claim 1, in which the shaper (44) is further adapted to shape the selected upmixed channel (50) using additional wave form parameters having a time resolution defined by the frame repetition rate.

**12.** Decoder in accordance with claim 1, further having an output interface to generate the multi-channel output signal having the high time resolution using the shaped selected upmixed channel (52).

**13.** Decoder in accordance with claim 12, in which the output interface is operative to generate the multi-channel output signal such that the generation of the multi-channel output signal comprises a synthesis of a filter bank representation of a plurality of shaped upmixed channels (52) resulting in a time domain representation of the plurality of shaped upmixed channels (52) having the high time resolution.

**14.** Decoder in accordance with claim 1, in which the shaper (44) is having a dequantizer for deriving the wave form parameter representation (48) from a quantized representation of the same, using a dequantization rule having less than 10 quantization steps.

**15.** Decoder in accordance with claim 14, in which the shaper (44) is having an entropy decoder for deriving the quantized representation of the wave form parameter representation (48) from an entropy encoded representation of the same.

**16.** Decoder in accordance with claim 15, in which the entropy decoder is operative to use a Huffman codebook for deriving the quantized representation of the wave form parameter representation (48).

**17.** Decoder in accordance with claim 2, in which the shaper (44) is operative to shape the selected upmixed channel (50) in the time domain.

**18.** Encoder for generating a wave form parameter representation (48) of a channel of a multi-channel signal having a frame (66), the frame (66) comprising sampling values (68a - 68g) having a sampling period, the encoder comprising:

a time resolution decreaser (62) for deriving a low time resolution representation (70) of the channel using the sampling values (68a - 68g) of the frame (66), the low time resolution representation (70) having low time resolution values (72a - 72d) having associated a low time resolution period being larger than the sampling period and for deriving a reference low time resolution representation of a base signal (46) derived from the multi-channel signal, the number of channels of the base signal (46) being smaller than the number of channels of the multi-channel signal; and
a wave form parameter calculator (64) for calculating the wave form parameter representation (48) representing a wave form of the low time resolution representation (70), wherein the wave form parameter calculator (64) is adapted to generate a sequence of wave form parameters (74), the sequence of wave form parameters (74) having a time resolution lower than a time resolution of the sampling values (68a - 68g) and higher than a time resolution defined by a frame repetition rate, wherein the wave form parameter calculator (64) is operative to calculate the wave form parameters (74) using the reference low time resolution representation and the low time resolution representation (70) of the channel.

19. Encoder in accordance with claim 18, in which the time resolution decreaser (62) is having a filter bank for deriving the low time resolution representation (70) of the channel, the low time resolution representation (70) of the channel being derived in a filter bank domain.

20. Encoder in accordance with claim 18, in which the waveform parameter calculator (64) is operative such that the calculation of the waveform parameters comprises a combination of amplitude measures of the reference low time resolution representation and of the low time resolution representation of the channel.

21. Encoder in accordance with claim 18, in which the waveform parameter calculator (64) is having a quantizer for deriving a quantized representation of the wave form parameters (74).

22. Encoder in accordance with claim 21, in which the waveform parameter calculator (64) is having an entropy encoder for deriving an entropy encoded representation of the quantized representation of the waveform parameters.

23. Method for generating a multi-channel output signal based on a base signal (46) derived from an original multi-channel signal having one or more channels, the number of channels of the base signal (46) being smaller than the number of channels of the original multi-channel signal, the base signal (46) having a frame (66), the frame (66) comprising sampling values (68a - 68g) having a high time resolution, wherein the generating the multi-channel output signal is additionally based on a wave form parameter representation (48) representing a wave form of a low time resolution representation of a selected original channel of the original multi-channel signal, wherein the wave form parameter representation (48) includes a sequence of wave form parameters (74), the sequence of wave form parameters (74) having a low time resolution lower than the high time resolution of the sampling values (68a - 68g) and higher than a time resolution defined by a frame repetition rate, the method comprising:

deriving a low time resolution representation of the base signal (46) used to generate a plurality of upmixed channels;
generating the plurality of upmixed channels having a time resolution higher than the low time resolution;
deriving a wave form parameter representation (48) of the low time resolution representation of the base signal (46); and
shaping an envelope of a selected upmixed channel (50) using the reference wave form parameter representation (48) and the wave form parameters (74) of the selected original channel corresponding to the selected upmixed channel (50).

24. Method for generating a wave form parameter representation (48) of a channel of a multi-channel signal having a frame (66), the frame (66) comprising sampling values (68a - 68g) having a sampling period, the method comprising:

deriving a low time resolution representation (70) of the channel using the sampling values (68a - 68g) of the frame (66), the low time resolution representation (70) having low time resolution values (72a - 72d) having associated a low time resolution period being larger than the sampling period;
deriving a reference low time resolution representation of a base signal (46) derived from the multi-channel signal, the number of channels of the base signal (46) being smaller than the number of channels of the multi-channel signal; and
calculating the wave form parameter representation (48) representing a wave form of the low time resolution representation (70) using the reference low time resolution representation and the low time resolution representation (70) of the channel, wherein the wave form parameter representation (48) includes a sequence of wave form parameters (74), the sequence of wave form parameters (74) having a time resolution lower than a time resolution of the sampling values (68a - 68g) and higher than a time resolution defined by a frame repetition rate.

25. Representation of a multi-channel audio signal based on a base signal (46) derived from the multi-channel audio signal having one or more channels, the number of channels of the base signal (46) being smaller than the number of channels of the multi-channel signal, the base signal (46) having a frame (66), the frame (66) comprising sampling values (68a - 68g) having a high time resolution, and based on a wave form parameter representation (48) representing a wave form of a low time resolution representation of a selected channel of the multi-channel signal, the wave form parameter representation (48) including a sequence of wave form parameters (74), the sequence of wave form parameters (74) having a time resolution lower than the high time resolution of the sampling values (68a - 68g) and higher than a time resolution defined by a frame repetition rate, wherein the representation of the multi-channel audio signal is generatable by an encoder of claim 18, or wherein the representation of the multi-channel audio signal is processable by a decoder of claim 1.

26. Computer readable storage medium, having stored thereon a representation in accordance with claim 25.

27. Receiver or audio player having a decoder in accordance with claim 1.

28. Transmitter or audio recorder having an encoder in accordance with claim 18.

29. Method of receiving or audio playing, the method having a method in accordance with claim 23.

30. Method of transmitting or audio recording, the method having a method in accordance with claim 24.

31. Transmission system having a transmitter and a receiver, the transmitter having an encoder in accordance with claim 18, and the receiver having a decoder in accordance with claim 1.

32. Method of transmitting and receiving, the method of transmitting having a method in accordance with claim 24, and the method of receiving having a method in accordance with claim 23.

33. Computer having a program code for, when running on the computer, performing any of the method claims 23, 24, 29, 30, or 32.

**Patentansprüche**

1. Ein Decodierer zum Erzeugen eines Multikanalausgangssignals basierend auf einem Basissignal (46), das aus einem ursprünglichen Multikanalsignal mit einem oder mehreren Kanälen abgeleitet wird, wobei eine Anzahl von Kanälen des Basissignals (46) kleiner ist als eine Anzahl von Kanälen des ursprünglichen Multikanalsignals, wobei das Basissignal (46) einen Rahmen (66) aufweist, wobei der Rahmen (66) Abtastwerte (68a - 68g) mit einer Hochzeitauflösung aufweist, wobei das Erzeugen des Multikanalausgangssignals zusätzlich auf einer Wellenformparameterdarstellung (48) basiert, die eine Wellenform einer Niedrigzeitauflösungsdarstellung eines ausgewählten ursprünglichen Kanals des ursprünglichen Multikanalsignals darstellt, wobei die Wellenformparameterdarstellung (48) eine Sequenz von Wellenformparametern (74) umfasst, die Sequenz von Wellenformparametern (74) eine Niedrigzeitauflösung aufweist, die niedriger ist als die Hochzeitauflösung der Abtastwerte (68a - 68g) und höher ist als eine durch eine Rahmenwiederholungsrate definierte Zeitauflösung, wobei der Decodierer folgende Merkmale aufweist:

   einen Aufwärtsmischer (42) zum Erzeugen einer Mehrzahl von aufwärtsgemischten Kanälen mit einer Zeitauflösung, die höher ist als die Niedrigzeitauflösung, und zum Ableiten einer Niedrigzeitauflösungsdarstellung des Basissignals (46), die dazu verwendet wird, die aufwärtsgemischteri Kanäle zu erzeugen; und
   einen Former (44) zum Ableiten einer Referenzwellenformparameterdarstellung (48) der Niedrigzeitauflösungsdarstellung des Basissignals (46) und zum Formen einer Hüllkurve eines ausgewählten aufwärtsgemischten Kanals (50) unter Verwendung der Referenzwellenformparameterdarstellung (48) und der Wellenformparameter (74) des ausgewählten ursprünglichen Kanals, die dem ausgewählten aufwärtsgemischten Kanal (50) entsprechen.

2. Decodierer gemäß Anspruch 1, bei dem der Aufwärtsmischer (42) dahingehend wirksam ist, die Niedrigzeitauflösungsdarstellung des Basissignals (46) unter Verwendung einer Filterbank abzuleiten, wobei die Niedrigzeitauflösungsdarstellung des Basissignals (46) in einem Filterbankbereich abgeleitet wird.

3. Decodierer gemäß Anspruch 2, bei dem die Filterbank eine komplexe modulierte Filterbank ist.

4. Decodierer gemäß Anspruch 1, bei dem der Aufwärtsmischer (42) einen oder mehrere Dekorrelatoren zum Ableiten eines oder mehrerer dekorrelierter Signale aus dem Basissignal (46) aufweist.

5. Decodierer gemäß Anspruch 4, bei dem der Aufwärtsmischer (42) derart wirksam ist, dass die Erzeugung der aufwärtsgemischten Kanäle eine lineare Kombination der Kanäle des Basissignals (46) und des einen oder der mehreren dekorrelierten Signale umfasst.

6. Decodierer gemäß Anspruch 5, bei dem der Former (44) dahingehend wirksam ist, den ausgewählten aufwärtsgemischten Kanal (50) derart zu formen, dass ein erster Teil des ausgewählten aufwärtsgemischten Kanals (50), der aus dem Basissignal (46) abgeleitet wird, unabhängig von einem zweiten Teil des ausgewählten aufwärtsgemischten Kanals (50) ist, der aus dem einen oder den mehreren dekorrelierten Signalen abgeleitet wird.

7. Decodierer gemäß Anspruch 1, bei dem der Former (44) dahingehend wirksam ist, die Wellenformparameter (74), die ein Signalstärkenmaß der Zwischenzeitauflösungsdarstellung des ausgewählten ursprünglichen Kanals beschreiben, zu nutzen.

8. Decodierer gemäß Anspruch 7, bei dem der Former (44) dahingehend wirksam ist, die Wellenformparameter (74), die das Signalstärkemaß mit einer Amplitude oder einem Energiemaß beschreiben, zu nutzen.

9. Decodierer gemäß Anspruch 1, bei dem der Former (44) dahingehend wirksam ist, den ausgewählten aufwärtsgemischten Kanal (50) derart zu formen, dass das Formen eine Kombination der Parameter aus der Wellenformparameterdarstellung (48) und aus der Referenzwellenformparameterdarstellung (48) aufweist.

10. Decodierer gemäß Anspruch 1, bei dem der Former (44) dahingehend wirksam ist, eine spektral flache Darstellung der Niedrigzeitauflösungsdarstellung des Basissignals (46) abzuleiten, wobei die spektral flache Darstellung ein flaches Frequenzspektrum aufweist, und die Referenzwellenformparameterdarstellung (48) aus der spektral flachen Darstellung abzuleiten.

11. Decodierer gemäß Anspruch 1, bei dem der Former (44) ferner dazu angepasst ist, den ausgewählten aufwärtsgemischten Kanal (50) unter Verwendung zusätzlicher Wellenformparameter mit einer durch die Rahmenwiederholungsrate definierten Zeitauflösung zu formen.

12. Decodierer gemäß Anspruch 1, der ferner eine Ausgangsschnittstelle aufweist, um das Multikanalausgangssignal mit der Hochzeitauflösung unter Verwendung des geformten ausgewählten aufwärtsgemischten Kanals (52) zu erzeugen.

13. Decodierer gemäß Anspruch 12, bei dem die Ausgangsschnittstelle dahingehend wirksam ist, das Multikanalausgangssignal derart zu erzeugen, dass die Erzeugung des Multikanalausgangssignals eine Synthese einer Filterbankdarstellung einer Mehrzahl von geformten aufwärtsgemischten Kanälen (52) aufweist, was eine Zeitbereichsdarstellung der Mehrzahl von geformten aufwärtsgemischten Kanälen (52) mit der Hochzeitauflösung zur Folge hat.

14. Decodierer gemäß Anspruch 1, bei dem der Former (44) einen Dequantisierer zum Ableiten der Wellenformparameterdarstellung (48) aus einer quantisierten Darstellung derselben unter Verwendung einer Dequantisierungsregel mit weniger als 10 Quantisierungsschritten aufweist.

15. Decodierer gemäß Anspruch 14, bei dem der Former (44) einen Entropiedecodierer zum Ableiten der quantisierten Darstellung der Wellenformparameterdarstellung (48) aus einer entropiecodierten Darstellung derselben aufweist.

16. Decodierer gemäß Anspruch 15, bei dem der Entropiedecodierer dahingehend wirksam ist, ein Huffman-Codebuch zum Ableiten der quantisierten Darstellung der Wellenformparameterdarstellung (48) zu verwenden.

17. Decodierer gemäß Anspruch 2, bei dem der Former (44) dahingehend wirksam ist, den ausgewählten aufwärtsgemischten Kanal (50) in dem Zeitbereich zu formen.

18. Codierer zum Erzeugen einer Wellenformparameterdarstellung (48) eines Kanals eines Multikanalsignals mit einem Rahmen (66), wobei der Rahmen (66) Abtastwerte (68a - 68g) mit einem Abtastzeitraum aufweist, wobei der Codierer folgende Merkmale aufweist:

einen Zeitauflösungsreduzierer (62) zum Ableiten einer Niedrigzeitauflösungsdarstellung (70) des Kanals unter Verwendung der Abtastwerte (68a - 68g) des Rahmens (66), wobei die Niedrigzeitauflösungsdarstellung (70) Niedrigzeitauflösungswerte (72a - 72d) aufweist, denen ein Niedrigzeitauflösungszeitraum zugewiesen ist, der größer ist als der Abtastzeitraum, und zum Ableiten einer Referenzniedrigzeitauflösungsdarstellung eines Basissignals (46), das aus dem Multikanalsignal abgeleitet wird, wobei die Anzahl an Kanälen des Basissignals (46) kleiner ist als die Anzahl an Kanälen des Multikanalsignals; und

einen Wellenformparameterrechner (64) zum Berechnen der Wellenformparameterdarstellung (48), die eine Wellenform der Niedrigzeitauflösungsdarstellung (70) darstellt, wobei der Wellenformparameterrechner (64) dazu angepasst ist, eine Sequenz von Wellenformparametern (74) zu erzeugen, wobei die Sequenz von Wellenformparametern (74) eine Zeitauflösung aufweist, die niedriger ist als eine Zeitauflösung der Abtastwerte (68a - 68g) und höher ist als eine durch eine Rahmenwiederholungsrate definierte Zeitauflösung, wobei der Wellenformparameterrechner (64) dahingehend wirksam ist, die Wellenformparameter (74) unter Verwendung der Referenzniedrigzeitauflösungsdarstellung und der Niedrigzeitauflösungsdarstellung (70) des Kanals zu berechnen.

**19.** Codierer gemäß Anspruch 18, bei dem der Zeitauflösungsreduzierer (62) eine Filterbank zum Ableiten der Niedrigzeitauflösungsdarstellung (70) des Kanals aufweist, wobei die Niedrigzeitauflösungsdarstellung (70) des Kanals in einem Filterbankbereich abgeleitet wird.

**20.** Codierer gemäß Anspruch 18, bei dem der Wellenformparameterrechner (64) derart wirksam ist, dass die Berechnung der Wellenformparameter eine Kombination von Amplitudenmaßen der Referenzniedrigzeitauflösungsdarstellung und der Niedrigzeitauflösungsdarstellung des Kanals aufweist.

**21.** Codierer gemäß Anspruch 18, bei dem der Wellenformparameterrechner (64) einen Quantisierer zum Ableiten einer quantisierten Darstellung der Wellenformparameter (74) aufweist.

**22.** Codierer gemäß Anspruch 21, bei dem der Wellenformparameterrechner (64) einen Entropiecodierer zum Ableiten einer entropiecodierten Darstellung der quantisierten Darstellung der Wellenformparameter aufweist.

**23.** Verfahren zum Erzeugen eines Multikanalausgangssignals basierend auf einem Basissignal (46), das aus einem ursprünglichen Multikanalsignal mit einem oder mehreren Kanälen abgeleitet wird, wobei die Anzahl von Kanälen des Basissignals (46) kleiner ist als die Anzahl von Kanälen des ursprünglichen Multikanalsignals, wobei das Basissignal (46) einen Rahmen (66) aufweist, wobei der Rahmen (66) Abtastwerte (68a - 68g) mit einer Hochzeitauflösung aufweist, wobei das Erzeugen des Multikanalausgangssignals zusätzlich auf einer Wellenformparameterdarstellung (48) basiert, die eine Wellenform einer Niedrigzeitauflösungsdarstellung eines ausgewählten ursprünglichen Kanals des ursprünglichen Multikanalsignals darstellt, wobei die Wellenformparameterdarstellung (48) eine Sequenz von Wellenformparametern (74) umfasst, die Sequenz von Wellenformparametern (74) eine Niedrigzeitauflösung aufweist, die niedriger ist als die Hochzeitauflösung der Abtastwerte (68a - 68g) und höher ist als eine durch eine Rahmenwiederholungsrate definierte Zeitauflösung, wobei das Verfahren folgende Schritte aufweist:

Ableiten einer Niedrigzeitauflösungsdarstellung des Basissignals (46), die dazu verwendet wird, die aufwärtsgemischten Kanäle zu erzeugen;
Erzeugen der Mehrzahl von aufwärtsgemischten Kanälen mit einer Zeitauflösung, die höher ist als die Niedrigzeitauflösung;
Ableiten einer Wellenformparameterdarstellung (48) der Niedrigzeitauflösungsdarstellung des Basissignals (46); und
Formen einer Hüllkurve eines ausgewählten aufwärtsgemischten Kanals (50) unter Verwendung der Referenzwellenformparameterdarstellung (48) und der Wellenformparameter (74) des ausgewählten ursprünglichen Kanals, die dem ausgewählten aufwärtsgemischten Kanal (50) entsprechen.

**24.** Verfahren zum Erzeugen einer Wellenformparameterdarstellung (48) eines Kanals eines Multikanalsignals mit einem Rahmen (66), wobei der Rahmen (66) Abtastwerte (68a - 68g) mit einem Abtastzeitraum aufweist, wobei das Verfahren folgende Schritte aufweist:

Ableiten einer Niedrigzeitauflösungsdarstellung (70) des Kanals unter Verwendung der Abtastwerte (68a - 68g) des Rahmens (66), wobei die Niedrigzeitauflösungsdarstellung (70) Niedrigzeitauflösungswerte (72a - 72d) aufweist, denen ein Niedrigzeitauflösungszeitraum zugewiesen ist, der größer ist als der Abtastzeitraum;
Ableiten einer Referenzniedrigzeitauflösungsdarstellung eines Basissignals (46), das aus dem Multikanalsignal abgeleitet wird, wobei die Anzahl an Kanälen des Basissignals (46) kleiner ist als die Anzahl an Kanälen des Multikanalsignals; und
Berechnen der Wellenformparameterdarstellung (48), die eine Wellenform der Niedrigzeitauflösungsdarstellung (70) darstellt, unter Verwendung der Referenzniedrigzeitauflösungsdarstellung und der Niedrigzeitauflösungsdarstellung (70) des Kanals, wobei die Wellenformparameterdarstellung (48) eine Sequenz von Wellenformparametern (74) umfasst, wobei die Sequenz von Wellenformparametern (74) eine Zeitauflösung aufweist, die niedriger ist als eine Zeitauflösung der Abtastwerte (68a - 68g) und höher ist als eine durch eine Rahmenwiederholungsrate definierte Zeitauflösung.

25. Darstellung eines Multikanalaudiosignals basierend auf einem Basissignal (46), das aus einem Multikanalaudiosignal mit einem oder mehreren Kanälen abgeleitet wird, wobei die Anzahl von Kanälen des Basissignals (46) kleiner ist als die Anzahl von Kanälen des Multikanalsignals, wobei das Basissignal (46) einen Rahmen (66) aufweist, wobei der Rahmen (66) Abtastwerte (68a - 68g) mit einer Hochzeitauflösung aufweist, und basierend auf einer Wellenformparameterdarstellung (48), die eine Wellenform einer Niedrigzeitauflösungsdarstellung eines ausgewählten Kanals des Multikanalsignals darstellt, wobei die Wellenformparameterdarstellung (48) eine Sequenz von Wellenformparametern (74) umfasst, die Sequenz von Wellenformparametern (74) eine Zeitauflösung aufweist, die niedriger ist als die Hochzeitauflösung der Abtastwerte (68a - 68g) und höher ist als eine durch eine Rahmenwiederholungsrate definierte Zeitauflösung,

wobei die Darstellung des Multikanalaudiosignals durch einen Codierer gemäß Anspruch 18 erzeugbar ist, oder wobei die Darstellung des Multikanalaudiosignals durch einen Decodierer gemäß Anspruch 1 verarbeitbar ist.

26. Computerlesbares Speichermedium, auf dem eine Darstellung gemäß Anspruch 25 gespeichert ist.

27. Empfänger oder Audiowiedergabevorrichtung mit einem Decodierer gemäß Anspruch 1.

28. Sender oder Audioaufzeichnungsvorrichtung mit einem Codierer gemäß Anspruch 18.

29. Verfahren zum Empfangen oder zur Audiowiedergabe, wobei das Verfahren ein Verfahren gemäß Anspruch 23 aufweist.

30. Verfahren zum Senden oder zur Audioaufzeichnung, wobei das Verfahren ein Verfahren gemäß Anspruch 24 aufweist.

31. Sendesystem mit einem Sender und einem Empfänger, wobei der Sender einen Codierer gemäß Anspruch 18 aufweist und der Empfänger einen Decodierer gemäß Anspruch 1 aufweist.

32. Verfahren zum Senden und Empfangen, wobei das Verfahren zum Senden ein Verfahren gemäß Anspruch 24 aufweist und das Verfahren zum Empfangen ein Verfahren gemäß Anspruch 23 aufweist.

33. Computer mit einem Programmcode zum Ausführen der Verfahren gemäß Anspruch 23, 24, 29, 30 oder 32, wenn derselbe auf dem Computer abläuft.

**Revendications**

1. Décodeur pour générer un signal de sortie multicanal sur base d'un signal de base (46) dérivé d'un signal multicanal original présentant un ou plusieurs canaux, un nombre de canaux du signal de base (46) étant inférieur à un nombre de canaux du signal multicanal original, le signal de base (46) présentant une trame (66), la trame (66) comprenant des valeurs d'échantillonnage (68a à 68g) présentant une haute résolution temporelle, dans lequel la génération du signal de sortie multicanal est par ailleurs basée sur une représentation de paramètres de forme d'onde (48) représentant une forme d'onde d'une représentation à faible résolution temporelle d'un canal original sélectionné du signal multicanal original, où la représentation de paramètres de forme d'onde (48) comporte une séquence de paramètres de forme d'onde (74), la séquence de paramètres de forme d'onde (74) présentant une faible résolution temporelle inférieure à la haute résolution temporelle des valeurs d'échantillonnage (68a à 68g) et supérieure à une résolution temporelle définie par un taux de répétition de trame, comprenant:

un mélangeur vers le haut (42) destiné à générer une pluralité de canaux mélangés vers le haut présentant une résolution temporelle supérieure à la faible résolution temporelle et à dériver une représentation à faible résolution temporelle du signal de base (46) utilisé pour générer les canaux mélangés vers le haut; et
un moyen de mise en forme (44) destiné à dériver une représentation de paramètres de forme d'onde de référence (48) de la représentation à faible résolution temporelle du signal de base (46) et à mettre en forme une enveloppe d'un canal mélangé vers le haut sélectionné (50) à l'aide de la représentation de paramètres de forme d'onde de référence (48) et des paramètres de forme d'onde (74) du canal original sélectionné correspondant au canal mélangé vers le haut sélectionné (50).

2. Décodeur selon la revendication 1, dans lequel le mélangeur vers le haut (42) est opérationnel pour dériver la représentation à faible résolution temporelle du signal de base (46) à l'aide d'un banc de filtres, où la représentation à faible résolution temporelle du signal de base (46) est dérivée dans un domaine de banc de filtres.

3. Décodeur selon la revendication 2, dans lequel le banc de filtres est un banc de filtres modulé complexe.

4. Décodeur selon la revendication 1, dans lequel le mélangeur vers le haut (42) présente un ou plusieurs décorrélateurs pour dériver un ou plusieurs signaux décorrélés du signal de base (46).

5. Décodeur selon la revendication 4, dans lequel le mélangeur vers le haut (42) est opérationnel de sorte que la génération des canaux mélangés vers le haut comporte une combinaison linéaire des canaux du signal de base (46) et des un ou plusieurs signaux décorrélés.

6. Décodeur selon la revendication 5, dans lequel le moyen de mise en forme (44) est opérationnel pour mettre en forme le canal mélangé vers le haut sélectionné (50) de sorte qu'une première partie du canal mélangé vers le haut sélectionné (50) dérivé du signal de base (46) soit mise en forme de manière indépendante de la deuxième partie du canal mélangé vers le haut sélectionné (50) dérivé des un ou plusieurs signaux décorrélés.

7. Décodeur selon la revendication 1, dans lequel le moyen de mise en forme (44) est opérationnel pour utiliser les paramètres de forme d'onde (74) décrivant une mesure d'intensité de signal de la représentation à résolution temporelle intermédiaire du canal original sélectionné.

8. Décodeur selon la revendication 7, dans lequel le moyen de mise en forme (44) est opérationnel pour utiliser les paramètres de forme d'onde (74) décrivant la mesure d'intensité de signal présentant une mesure d'amplitude ou d'énergie.

9. Décodeur selon la revendication 1, dans lequel le moyen de mise en forme (44) est opérationnel pour mettre en forme le canal mélangé vers le haut sélectionné (50) de sorte que la mise en forme comprenne une combinaison des paramètres de la représentation de paramètres de forme d'onde (48) et de la représentation de paramètres de forme d'onde de référence (48).

10. Décodeur selon la revendication 1, dans lequel le moyen de mise en forme (44) est opérationnel pour dériver une représentation spectralement plane de la représentation à faible résolution temporelle du signal de base (46), la représentation spectralement plane présentant un spectre de fréquence plan, et pour dériver la représentation de paramètres de forme d'onde de référence (48) de la représentation spectrale plane.

11. Décodeur selon la revendication 1, dans lequel le moyen de mise en forme (44) est par ailleurs adapté pour mettre en forme le canal mélangé vers le haut sélectionné (50) à l'aide de paramètres de forme d'onde additionnels présentant une résolution temporelle définie par le taux de répétition de trame.

12. Décodeur selon la revendication 1, présentant par ailleurs une interface de sortie destinée à générer le signal de sortie multicanal présentant la haute résolution temporelle à l'aide du canal mélangé vers le haut sélectionné (52).

13. Décodeur selon la revendication 12, dans lequel l'interface de sortie est opérationnelle pour générer le signal de sortie multicanal de sorte que la génération du signal de sortie multicanal comprenne une synthèse d'une représentation de banc de filtres d'une pluralité de canaux mélangés vers le haut mis en forme (52) résultant en une représentation dans le domaine temporel de la pluralité de canaux mélangés vers le haut mis en forme (52) présentant la haute résolution temporelle.

14. Décodeur selon la revendication 1, dans lequel le moyen de mise en forme (44) présente un déquantificateur destiné à dériver la représentation de paramètres de forme d'onde (48) d'une représentation quantifiée de cette dernière, à l'aide d'une règle de déquantification présentant moins de 10 étapes de quantification.

15. Décodeur selon la revendication 14, dans lequel le moyen de mise en forme (44) présente un décodeur entropique destiné à dériver la représentation quantifiée de la représentation de paramètres de forme d'onde (48) d'une représentation codée de manière entropique de cette dernière.

**16.** Décodeur selon la revendication 15, dans lequel le décodeur entropique est opérationnel pour utiliser un livre de codes de Huffman pour dériver la représentation quantifiée de la représentation de paramètres de forme d'onde (48).

**17.** Décodeur selon la revendication 2, dans lequel le moyen de mise en forme (44) est opérationnel pour mettre en forme le canal mélangé vers le haut sélectionné (50) dans le domaine temporel.

**18.** Codeur pour générer une représentation de paramètres de forme d'onde (48) d'un canal d'un signal multicanal présentant une trame (66), la trame (66) comprenant des valeurs d'échantillonnage (68a à 68g) présentant une période d'échantillonnage, le codeur comprenant:

un moyen d'abaissement de résolution temporelle (62) destiné à dériver une représentation à faible résolution temporelle (70) du canal à l'aide des valeurs d'échantillonnage (68a à 68g) de la trame (66), la représentation à faible résolution temporelle (70) présentant des valeurs de faible résolution temporelle (72a à 72d) présentant, y associée, une période de faible résolution temporelle qui est supérieure à la période d'échantillonnage, et à dériver une représentation à faible résolution temporelle de référence d'un signal de base (46) dérivé du signal multicanal, le nombre de canaux du signal de base (46) étant inférieur au nombre de canaux du signal multicanal; et

un calculateur de paramètres de forme d'onde (64) destiné à calculer la représentation de paramètres de forme d'onde (48) représentant une forme d'onde de la représentation à faible résolution temporelle (70), où le calculateur de paramètres de forme d'onde (64) est adapté pour générer une séquence de paramètres de forme d'onde (74), la séquence de paramètres de forme d'onde (74) présentant une résolution temporelle inférieure à une résolution temporelle des valeurs d'échantillonnage (68a à 68g) et supérieure à une résolution temporelle définie par un taux de répétition de trame, où le calculateur de paramètres de forme d'onde (64) est opérationnel pour calculer les paramètres de forme d'onde (74) à l'aide de la représentation à faible résolution temporelle de référence et de la représentation à faible résolution temporelle (70) du canal.

**19.** Codeur selon la revendication 18, dans lequel le moyen d'abaissement de résolution temporelle (62) présente un banc de filtres destiné à dériver la représentation à faible résolution temporelle (70) du canal, la représentation à faible résolution temporelle (70) du canal étant dérivée dans un domaine de banc de filtres.

**20.** Codeur selon la revendication 18, dans lequel le calculateur de paramètres de forme d'onde (64) est opérationnel de sorte que le calcul des paramètres de forme d'onde comprenne une combinaison de mesures d'amplitude de la représentation à faible résolution temporelle de référence et de la représentation à faible résolution temporelle du canal.

**21.** Codeur selon la revendication 18, dans lequel le calculateur de paramètres de forme d'onde (64) présente un quantificateur destiné à dériver une représentation quantifiée des paramètres de forme d'onde (74).

**22.** Codeur selon la revendication 21, dans lequel le calculateur de paramètres de forme d'onde (64) présente un codeur entropique destiné à dériver une représentation codée de manière entropique de la représentation quantifiée des paramètres de forme d'onde.

**23.** Procédé de génération d'un signal de sortie multicanal sur base d'un signal de base (46) dérivé d'un signal original multicanal présentant un ou plusieurs canaux, le nombre de canaux du signal de base (46) étant inférieur au nombre de canaux du signal multicanal original, le signal de base (46) présentant une trame (66), la trame (66) comprenant des valeurs d'échantillonnage (68a à 68g) présentant une haute résolution temporelle, dans lequel la génération du signal de sortie multicanal est basée en outre sur une représentation de paramètres de forme d'onde (48) représentant une forme d'onde d'une représentation à faible résolution temporelle d'un canal original sélectionné du signal multicanal original, où la représentation de paramètres de forme d'onde (48) comporte une séquence de paramètres de forme d'onde (74), la séquence de paramètres de forme d'onde (74) présentant une faible résolution temporelle inférieure à la haute résolution temporelle des valeurs d'échantillonnage (68a à 68g) et supérieure à une résolution temporelle définie par un taux de répétition de trame, le procédé comprenant le fait de:

dériver une représentation à faible résolution temporelle du signal de base (46) utilisé pour générer une pluralité de canaux mélangés vers le haut;
générer la pluralité de canaux mélangés vers le haut présentant une résolution temporelle supérieure à la faible résolution temporelle;

dériver une représentation de paramètres de forme d'onde (48) de la représentation à faible résolution temporelle du signal de base (46); et

mettre en forme une enveloppe d'un canal mélangé vers le haut sélectionné (50) à l'aide de la représentation de paramètres de forme d'onde de référence (48) et des paramètres de forme d'onde (74) du canal original sélectionné correspondant au canal mélangé vers le haut sélectionné (50).

24. Procédé pour générer une représentation de paramètres de forme d'onde (48) d'un canal d'un signal multicanal présentant une trame (66), la trame (66) comprenant des valeurs d'échantillonnage (68a à 68g) présentant une période d'échantillonnage, le procédé comprenant le fait de:

dériver une représentation à faible résolution temporelle (70) du canal à l'aide des valeurs d'échantillonnage (68a à 68g) de la trame (66), la représentation à faible résolution temporelle (70) présentant des valeurs de faible résolution temporelle (72a à 72d) présentant, y associée, une période de faible résolution temporelle qui est supérieure à la période d'échantillonnage;

dériver une représentation à faible résolution temporelle de référence d'un signal de base (46) dérivé du signal multicanal, le nombre de canaux du signal de base (46) étant inférieur au nombre de canaux du signal multicanal; et

calculer la représentation de paramètres de forme d'onde (48) représentant une forme d'onde de la représentation à faible résolution temporelle (70) à l'aide de la représentation à faible résolution temporelle de référence et de la représentation à faible résolution temporelle (70) du canal, où la représentation de paramètres de forme d'onde (48) comporte une séquence de paramètres de forme d'onde (74), la séquence de paramètres de forme d'onde (74) présentant une résolution temporelle inférieure à une résolution temporelle des valeurs d'échantillonnage (68a à 68g) et supérieure à une résolution temporelle définie par un taux de répétition de trame.

25. Représentation d'un signal audio multicanal basée sur un signal de base (46) dérivé du signal audio multicanal présentant un ou plusieurs canaux, le nombre de canaux du signal de base (46) étant inférieur au nombre de canaux du signal multicanal, le signal de base (46) présentant une trame (66), la trame (66) comprenant des valeurs d'échantillonnage (68a à 68g) présentant une haute résolution temporelle, et basée sur une représentation de paramètres de forme d'onde (48) représentant une forme d'onde d'une représentation à faible résolution temporelle d'un canal sélectionné du signal multicanal, la représentation de paramètres de forme d'onde (48) comportant une séquence de paramètres de forme d'onde (74), la séquence de paramètres de forme d'onde (74) présentant une résolution temporelle inférieure à la haute résolution temporelle des valeurs d'échantillonnage (68a à 68g) et supérieure à une résolution temporelle définie par un taux de répétition de trame,

dans lequel la représentation du signal audio multicanal peut être générée par un codeur selon la revendication 18, ou dans lequel la représentation du signal audio multicanal peut être traitée par un décodeur selon la revendication 1.

26. Support de mémoire lisible par ordinateur présentant, y mémorisée, une représentation selon la revendication 25.

27. Récepteur ou reproducteur audio présentant un décodeur selon la revendication 1.

28. Emetteur ou reproducteur audio présentant un codeur selon la revendication 18.

29. Procédé de réception ou de reproduction audio, le procédé présentant un procédé selon la revendication 23.

30. Procédé de transmission ou d'enregistrement audio, le procédé présentant un procédé selon la revendication 24.

31. Système d'émission présentant un émetteur et un récepteur, l'émetteur présentant un codeur selon la revendication 18, et le récepteur présentant un décodeur selon la revendication 1.

32. Procédé d'émission et de réception, le procédé d'émission présentant un procédé selon la revendication 24, et le procédé de réception présentant un procédé selon la revendication 23.

33. Ordinateur présentant un code de programme pour réaliser, lorsqu'il est exécuté sur l'ordinateur, l'une quelconque des revendications de procédé 23, 24, 29, 30 ou 32.

# FIG 1

base signal

upmixer — 42

waveform parameter representation

46

48

50

shaper

44

shaped upmixed channel

52

40

# FIG 2

frame

68a······68g

66

time resolution decreaser — 62

low-res — 70

72a······72d

waveform parameter calculator — 64

waveform parameters

74

60

# FIG 3A

| k | $\bar{K}(k)$ | | k | $\bar{K}(k)$ | |
|---|---|---|---|---|---|
| | dec Type=0 | dec Type=1 | | dec Type=0 | dec Type=1 |
| 0 | 1 | 0 | 53 | 19 | 15 |
| 1 | 0 | 0 | 54 | 19 | 15 |
| 2 | 0 | 1 | 55 | 19 | 16 |
| 3 | 1 | 1 | 56 | 19 | 16 |
| 4 | 2 | 2 | 57 | 19 | 16 |
| 5 | 3 | 2 | 58 | 19 | 16 |
| 6 | 4 | 3 | 59 | 19 | 17 |
| 7 | 5 | 3 | 60 | 19 | 17 |
| 8 | 6 | 4 | 61 | 19 | 17 |
| 9 | 7 | 4 | 62 | 19 | 17 |
| 10 | 8 | 4 | 63 | 19 | 17 |
| 11 | 9 | 4 | 64 | 19 | 18 |
| 12 | 10 | 1 | 65 | 19 | 18 |
| 13 | 11 | 1 | 66 | 19 | 18 |
| 14 | 12 | 0 | 67 | 19 | 18 |
| 15 | 13 | 0 | 68 | 19 | 18 |
| 16 | 14 | 6 | 69 | 19 | 18 |
| 17 | 14 | 6 | 70 | 19 | 18 |
| 18 | 15 | 3 | 71 | | 18 |
| 19 | 15 | 3 | 72 | | 18 |
| 20 | 15 | 4 | 73 | | 18 |
| 21 | 16 | 4 | 74 | | 18 |
| 22 | 16 | 5 | 75 | | 18 |
| 23 | 16 | 5 | 76 | | 19 |
| 24 | 16 | 6 | 77 | | 19 |
| 25 | 17 | 6 | 78 | | 19 |
| 26 | 17 | 7 | 79 | | 19 |
| 27 | 17 | 7 | 80 | | 19 |
| 28 | 17 | 8 | 81 | | 19 |
| 29 | 17 | 8 | 82 | | 19 |
| 30 | 18 | 5 | 83 | | 19 |
| 31 | 18 | 5 | 84 | | 19 |
| 32 | 18 | 9 | 85 | | 19 |
| 33 | 18 | 7 | 86 | | 19 |
| 34 | 18 | 8 | 87 | | 19 |
| 35 | 18 | 8 | 88 | | 19 |
| 36 | 18 | 9 | 89 | | 19 |
| 37 | 18 | 9 | 90 | | 19 |
| 38 | 18 | 10 | 91 | | 19- |
| 39 | 18 | 8 | 92 | | 19 |
| 40 | 18 | 11 | 93 | | 19 |
| 41 | 18 | 9 | 94 | | 19 |

## FIG 3B

| 80 | 82a | 82b | 80 | 82a | 82b |
|----|-----|-----|-----|-----|-----|
| 42 | 19 | 10 | 95 | | 19 |
| 43 | 19 | 10 | 96 | | 19 |
| 44 | 19 | 11 | 97 | | 19 |
| 45 | 19 | 11 | 98 | | 19 |
| 46 | 19 | 12 | 99 | | 19 |
| 47 | 19 | 10 | 100 | | 19 |
| 48 | 19 | 12 | 101 | | 19 |
| 49 | 19 | 13 | 102 | | 19 |
| 50 | 19 | 14 | 103 | | 19 |
| 51 | 19 | 14 | 104 | | 19 |
| 52 | 19 | 15 | | | |

## FIG 4

| 84 → | dec Type | 0 | 1 |
|------|----------|---|---|
| | $k_0$ | 12 | 40 |

# FIG 5

| Syntax | No. of bits | Mnemonic |
|---|---|---|
| SpatialSpecificConfig() | | |
| { | | |
|     bsSamplingFrequencyIndex; | 4 | uimsbf |
|     if ( samplingFrequencyIndex==0xf ) { | | |
|         bsSamplingFrecuncy; | 24 | uimsbf |
|     } | | |
|     bsFrameLength; | 6 | uimsbf |
|     bsFreqRes; | 3 | uimsbf |
|     bsTreeConfig; | 4 | uimsbf |
|     bsQuantMode; | 3 | uimsbf |
|     bsOnelcc; | 1 | uimsbf |
|     bsArbitraryDownmix; | 1 | uimsbf |
|     bsResidualCoding; | 1 | uimsbf |
|     bsSmoothConfig; | 4 | uimsbf |
|     bsFixedGains; | 4 | uimsbf |
|     bsMatrixMode; | 1 | uimsbf |
|     bsTempShapeConfig; | 4 | uimsbf |
|     bsDecorrConfig; | 4 | uimsbf |
|     if (bsTreeConfig==15) { | | |
|         TreeDescription(); | | |
|     } | | |
|     for(i=0; i<numOttBoxes; i++) { | | Note 1 |
|         OttConfig(i) | | |
|     } | | |
|     for(i=0; i<numTttBoxes; i++) { | | Note 1 |
|         TttConfig(i) | | |
|     } | | |
|     if(bsResidualCoding) { | | |
|         bsResidualSamplingFrequencyindex; | 4 | uimsbf |
|         bsResidualFramesPerSpatialFrame; | 2 | uimsbf |
|         for(i=0; i<numOttBoxes+numTttBoxes; i++) { | | Note 1 |
|             ResidualConfig(i); | | |
|         } | | |
|     } | | |
|     if ((bsTempShape Config>=4)&& (bsTempShapeConfig<8)) { | | |
|         bsEnvQuantMode | 3 | uimsbf |
|     } | | |
| | | |
|     /*SOME CONTAINER FOR LATER EXTENSIONS SHOULD GO HERE*/ | | |
| | | |
| } | | |
| Note 1: numOttBoxes and numTttBoxes are defined dependent on bsTreeConfig. | | |

# FIG 6

| bsTempSampleConfig | Meaning |
|---|---|
| 0 | use TP without whitening if available in decoder, otherwise use TES |
| 1 | use TP with whitening if available in decoder, otherwise use TES |
| 2 | only TES (even if TP available in decoder) |
| 3 | no temporal shaping |
| 4..7 | same as 0...3, combined with guided envelope shaping |
| 8..15 | reserved |

94

# FIG 7

| Syntax | No. of bits | Mnemonic |
|---|---|---|
| TempShapeData() | | |
| { | | |
|     bsTempShapeEnable; | 1 | uimsbf |
|     if (bsTempShapeEnable) { | | |
|         for (oc=0; oc<numOutChan; oc++) { | | |
|             bsTempShapeEnableChannel[oc]; | 1 | uimsbf |
|         } | | |
|     } | | |
|     if ((bsTempShapeConfig>=4)&&(bsTempShapeConfig<8)) { | | |
|         EnvelopeReshapeHuff(numOutChan, numTimeSlots) | | |
|     } | | |
| } | | |

100

102

# FIG 8

| Syntax | No. of bits | Mnemonic |
|---|---|---|
| EnvelopeReshapeHuff( numOutChan; numTimeSlots )<br>{<br>   for (i=0; i<numOutChan; i++) {<br>      bsEnvShapeChannel;<br>      if (bsEnvShapeChannel) {<br>         numValRcvd=0;<br>         while (numValRcvd<numTimeSlots) {<br>            (erVal, erLen)=2Dhuff_dec(hcod2D_EnvRes, bsCodeW);<br>            for (k=numValRcvd; k<numValRcvd+erLen; k++) {<br>               envShapeData[i][k]=erVal;<br>            }<br>            numValRcvd+=erLen;<br>         }<br>      }<br>   }<br>   return envShapeData;<br>} | <br><br><br>1<br><br><br><br><br>1...x | <br><br><br>uimsbf<br><br><br><br><br>vlclbf |

104

106

# FIG 7B

| bsEnvQuantMode | Meaning |
|---|---|
| 0 | 5-step quantizer |
| 1..7 | reserved |

## FIG 9

Table A1 - hcod2D_EnvRes

| erVal | erLen | lenght | codeword | erVal | erLen | lenght | codeword |
|-------|-------|--------|----------|-------|-------|--------|----------|
| -2 | 1 | 5 | 0x006 | 0 | 5 | 5 | 0x007 |
| -2 | 2 | 6 | 0x01e | 0 | 6 | 6 | 0x03a |
| -2 | 3 | 8 | 0x0f8 | 0 | 7 | 6 | 0x01f |
| -2 | 4 | 9 | 0x1f2 | 0 | 8 | 5 | 0x01e |
| -2 | 5 | 10 | 0x3e6 | 1 | 1 | 3 | 0x002 |
| -2 | 6 | 11 | 0x7ce | 1 | 2 | 4 | 0x006 |
| -2 | 7 | 11 | 0x17e | 1 | 3 | 5 | 0x004 |
| -2 | 8 | 10 | 0x3ee | 1 | 4 | 7 | 0x07e |
| -1 | 1 | 3 | 0x004 | 1 | 5 | 8 | 0x0fa |
| -1 | 2 | 4 | 0x00a | 1 | 6 | 9 | 0x1f6 |
| -1 | 3 | 5 | 0x00e | 1 | 7 | 10 | 0x3ff |
| -1 | 4 | 6 | 0x00a | 1 | 8 | 9 | 0x05e |
| -1 | 5 | 7 | 0x016 | 2 | 1 | 6 | 0x03b |
| -1 | 6 | 9 | 0x1fe | 2 | 2 | 8 | 0x0fe |
| -1 | 7 | 10 | 0x3fe | 2 | 3 | 9 | 0x05d |
| -1 | 8 | 9 | 0x05c | 2 | 4 | 10 | 0x0be |
| 0 | 1 | 3 | 0x006 | 2 | 5 | 11 | 0x17f |
| 0 | 2 | 3 | 0x000 | 2 | 6 | 12 | 0xf9e |
| 0 | 3 | 4 | 0x00b | 2 | 7 | 12 | 0xf9f |
| 0 | 4 | 5 | 0x01c | 2 | 8 | 10 | 0x3ef |

## FIG 10

| oc | X |
|----|---|
| 0 | L |
| 1 | R |
| 2 | C |
| 3 | Lfe |
| 4 | Ls |
| 5 | Rs |

## FIG 11

Multi
channel
sinal →

332

330

50 60

334

→ Transmit/
Store

## FIG 12

Receiver
Read →

342

340

344

180 40

→ Playback/
Output

## FIG 13

Multi
channel
sinal →

332

330

334

342

340

344

→ Playback/
Output

# FIG 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1565036 A

- EP 1385150 A

### Non-patent literature cited in the description

- Report on MPEG Spatial Audio Coding RM0 Listening Tests. *ISO/IEC JTC1/SC29/WG11 (MPEG),* 2005